(19) Europäisches Patentamt
European Patent Office
Office européen des brevets

(11) **EP 3 439 002 A1**

(12) **EUROPEAN PATENT APPLICATION**
published in accordance with Art. 153(4) EPC

(43) Date of publication:
**06.02.2019 Bulletin 2019/06**

(21) Application number: **17773819.2**

(22) Date of filing: **17.02.2017**

(51) Int Cl.:
***H01G 9/20*** *(2006.01)* ***C09B 57/10*** *(2006.01)*
***C09B 67/44*** *(2006.01)* ***H01L 51/44*** *(2006.01)*
***C07D 213/22*** *(2006.01)* ***C07D 213/38*** *(2006.01)*
***C07D 213/79*** *(2006.01)* ***C07D 409/14*** *(2006.01)*
***C07F 15/00*** *(2006.01)*

(86) International application number:
**PCT/JP2017/005987**

(87) International publication number:
**WO 2017/169271 (05.10.2017 Gazette 2017/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **30.03.2016 JP 2016067576**
**06.02.2017 JP 2017019718**

(71) Applicant: **Fujifilm Corporation**
**Minato-ku**
**Tokyo 106-8620 (JP)**

(72) Inventors:
- **YOSHIOKA Tomoaki**
  **Ashigarakami-gun**
  **Kanagawa 258-8577 (JP)**
- **SASAKI, Koitsu**
  **Ashigarakami-gun**
  **Kanagawa 258-8577 (JP)**
- **WATANABE, Kohsuke**
  **Ashigarakami-gun,**
  **Kanagawa 2588577 (JP)**

(74) Representative: **Hoffmann Eitle**
**Patent- und Rechtsanwälte PartmbB**
**Arabellastraße 30**
**81925 München (DE)**

# (54) DYE SOLUTION FOR PHOTOELECTRIC CONVERSION ELEMENT, PREPARATION KIT FOR DYE SOLUTION, AND MANUFACTURING METHOD FOR PHOTOELECTRIC CONVERSION ELEMENT

(57) Provided are a dye solution for a photoelectric conversion element and a kit for preparing a dye solution, each of which is capable of enhancing the photoelectric conversion efficiency of a photoelectric conversion element thus obtained, even in a low-illuminance environment, and even with a shortened adsorption time, by being used in the production of the photoelectric conversion element; and a method for producing a photoelectric conversion element. The dye solution for a photoelectric conversion element contains at least one metal complex dye represented by a specific formula and a solvent including at least one alcohol solvent having a specific structure.

FIG. 1

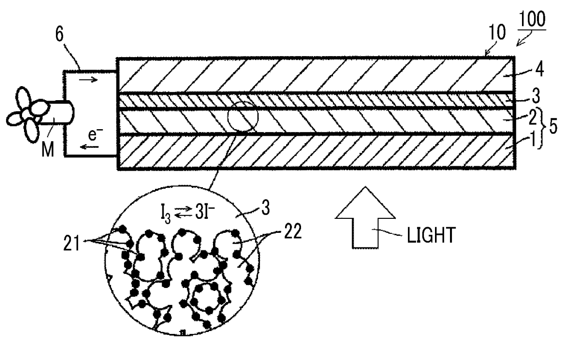


EP 3 439 002 A1

## Description

## BACKGROUND OF THE INVENTION

1. Field of the Invention

The present invention relates to a dye solution for a photoelectric conversion element, a kit for preparing a dye solution, and a method for producing a photoelectric conversion element.

2. Description of the Related Art

Photoelectric conversion elements are used in various photosensors, copying machines, photoelectrochemical cells such as solar cells, and the like. These photoelectric conversion elements have adopted various systems to be put into use, such as systems utilizing metals, systems utilizing semiconductors, systems utilizing organic pigments or dyes, or combinations of these elements. In particular, solar cells utilizing inexhaustible solar energy do not necessitate fuels, and full-fledged practicalization of solar cells as an inexhaustible clean energy is being highly expected. Above all, research and development of silicon-based solar cells have long been in progress, and many countries also support policy-wise considerations, and thus dissemination of silicon-based solar cells is still in progress. However, silicon is an inorganic material, and thus, naturally has limitations in terms of improvement of throughput, cost, and the like.

Thus, research is being vigorously carried out on photoelectrochemical cells (also referred to as dye-sensitized solar cells) using metal complex dyes. In particular, what have built momentum toward such research was research results from Graetzel et al. of École Polytechnique Fédérale de Lausanne in Switzerland. They employed a structure in which a dye formed from a ruthenium complex was fixed (adsorbed) on the surface of a porous titanium oxide film, and realized a photoelectric conversion efficiency which was comparable to that of amorphous silicon. Thus, dye-sensitized solar cells that can be produced even without use of expensive vacuum devices have instantly attracted the attention of researchers all over the world.

In such dye-sensitized solar cells, examples of a method for adsorbing a metal complex dye onto a carrier such as a porous titanium oxide film include a method in which a carrier is immersed in a dye solution containing a metal complex dye.

For example, JP2013-072079A specifically describes a method in which a laminate formed with a titanium oxide particle containing composition is immersed in an ethanol solution of a metal complex dye having a specific structure (paragraphs 0192 and the like of the same publication). Further, JP2001-291534A specifically describes a method in which a $TiO_2$ electrode is immersed in a methanol solution of a metal complex dye having a specific structure (paragraphs 0265 and the like of the same publication).

## SUMMARY OF THE INVENTION

The applications of a photoelectric conversion element and a dye-sensitized solar cell have been extended and are used in various environments. Examples of such environments include a low-illuminance environment with an illuminance lower than that of solar light in a clear weather (high-illuminance environment), such as an environment under irradiation with solar light in a cloudy weather, a rainy weather, or the like, or a low-illuminance environment in indoors or by an illumination device such as a fluorescent light lamp. Therefore, recent photoelectric conversion elements and dye-sensitized solar cells have been demanded to exhibit sufficient photoelectric conversion efficiency even in a low-illuminance environment as well as a high-illuminance environment.

Moreover, the photoelectric conversion element and the dye-sensitized solar cell have also been required to have improvement of production efficiency. Adsorption of a metal complex dye has limitations in a temperature and the like, and generally, requires several tens of hours. Therefore, as long as it is possible to reduce the adsorption time of the dye, such the reduction can make a great contribution to the improvement of production efficiency.

However, a photoelectric conversion element in which a metal complex dye is adsorbed by a method in the related art has not been sufficient, particularly in terms of photoelectric conversion efficiency in a low-illuminance environment. This becomes more apparent in a case where the adsorption time of the dye is shortened in order to improve the production efficiency.

An object of the present invention is to provide a dye solution for a photoelectric conversion element and a kit for preparing a dye solution, each of which is capable of enhancing the photoelectric conversion efficiency of a photoelectric conversion element thus obtained, even in a low-illuminance environment, and even with a shortened adsorption time, by being used in the production of the photoelectric conversion element. In addition, another object of the present invention is to provide a method for producing a photoelectric conversion element, using the dye solution for a photoelectric conversion element.

The present inventors have made various investigations on a photoelectric conversion element and a method for producing a dye-sensitized solar cell, and have thus found that a dye solution including a metal complex dye having a specific chemical structure and an alcohol solvent having a specific chemical structure is effective for adsorption of the metal complex dye onto semiconductor fine particles, and that a photoelectric conversion element in which a metal complex dye is adsorbed on semiconductor fine particles using the dye solution exhibits high photoelectric conversion efficiency even with a short adsorption time and even in a low-illuminance environment. Based on these findings, the present invention has been completed through repeated extensive studies.

That is, the objects of the present invention have been accomplished by the following means.

<1> A dye solution for a photoelectric conversion element, comprising:

at least one metal complex dye represented by Formula (1); and
a solvent including at least one alcohol solvent having a molecular weight of 70 to 300, selected from a primary alcohol having 4 or more carbon atoms in total, which has at least one branched chain, a secondary alcohol having 4 or more carbon atoms in total, which may have a branched chain, and a tertiary alcohol having 5 or more carbon atoms in total, which may have a branched chain,

Formula (1) 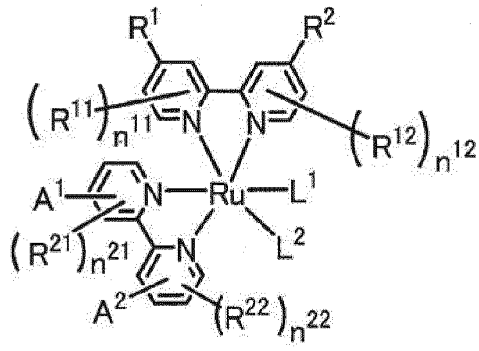

in the formula,

$R^1$ and $R^2$ each independently represent a carboxyl group or a salt thereof, an alkyl group, an ethenyl group, an ethynyl group, an aryl group, a heteroaryl group, an alkoxy group, an alkylthio group, an aryloxy group, an arylthio group, an amino group, or a monovalent group formed by combination of two or more of these groups,
$R^{11}$ and $R^{12}$ each independently represent an alkyl group, an alkenyl group, an alkoxy group, an aryl group, an alkylthio group, a heteroaryl group, an amino group, or a halogen atom, and $R^{11}$ and $R^{12}$ may be linked to each other to form a ring,
$n^{11}$ and $n^{12}$ are each independently an integer of 0 to 3,
$A^1$ and $A^2$ each independently represent an acidic group,
$R^{21}$ and $R^{22}$ each independently represent an alkyl group, an alkenyl group, an aryl group, a cyano group, a halogen atom, or an acidic group, and $R^{21}$ and $R^{22}$ may be linked to each other to form a ring,
$n^{21}$ and $n^{22}$ are each independently an integer of 0 to 3, and
$L^1$ and $L^2$ each independently represent a monodentate ligand, or $L^1$ and $L^2$ represent a bidentate ligand formed by the mutual linking thereof.

<2> The dye solution for a photoelectric conversion element as described in <1>,
in which the metal complex dye is represented by Formula (2),

Formula (2) 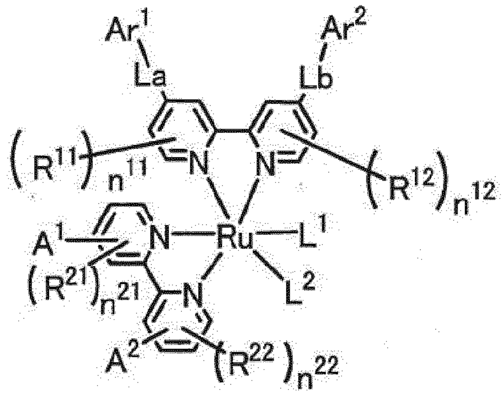

in the formula,

La and Lb each independently represent a single bond, or a conjugated linking group selected from an ethenylene group, an ethynylene group, an arylene group, and a heteroarylene group,
$Ar^1$ and $Ar^2$ each independently represent an aryl group or a heteroaryl group, and $R^{11}$, $R^{12}$, $n^{11}$, $n^{12}$, $A^1$, $A^2$, $R^{21}$, $R^{22}$, $n^{21}$, $n^{22}$, $L^1$, and $L^2$ have the same definitions as $R^{11}$, $R^{12}$, $n^{11}$, $n^{12}$, $A^1$, $A^2$, $R^{21}$, $R^{22}$, $n^{21}$, $n^{22}$, $L^1$, and $L^2$ in Formula (1), respectively.

<3> The dye solution for a photoelectric conversion element as described in <2>,
in which $Ar^1$ and $Ar^2$ each independently have an alkyl group, an alkoxy group, an alkylthio group, or an amino group as a substituent.
<4> The dye solution for a photoelectric conversion element as described in <2> or <3>,
in which La and Lb are each an ethenylene group.
<5> The dye solution for a photoelectric conversion element as described in any one of <1> to <4>,
in which the metal complex dye is represented by Formula (3),

Formula (3) 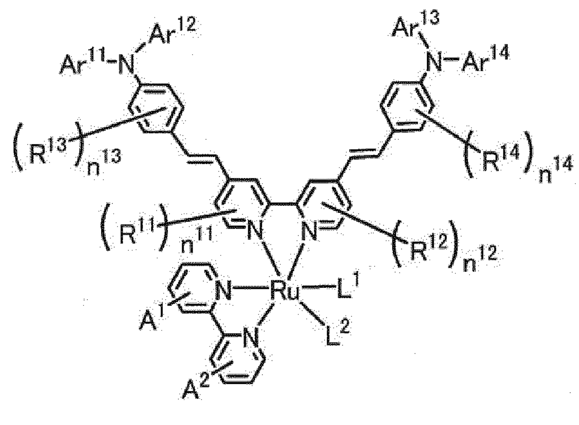

in the formula,

$Ar^{11}$ to $Ar^{14}$ each independently represent an aryl group or a heteroaryl group,
$R^{13}$ and $R^{14}$ each independently represent an alkyl group, an alkoxy group, an aryl group, an alkylthio group, a heteroaryl group, an amino group, or a halogen atom,
$n^{13}$ and $n^{14}$ are each independently an integer of 0 to 4, and
$R^{11}$, $R^{12}$, $n^{11}$, $n^{12}$, $A^1$, $A^2$, $L^1$, and $L^2$ have the same definitions as $R^{11}$, $R^{12}$, $n^{11}$, $n^{12}$, $A^1$, $A^2$, $L^1$, and $L^2$ in Formula (1), respectively.

<6> The dye solution for a photoelectric conversion element as described in any one of <1> to <5>,
in which $L^1$ and $L^2$ are each independently an isothiocyanate group, a thiocyanate group, an isoselenocyanate group, an isocyanate group, a cyanate group, a halogen atom, a cyano group, an alkylthio group, an arylthio group, an alkoxy group, or an aryloxy group.
<7> The dye solution for a photoelectric conversion element as described in any one of <1> to <6>,

in which the molecular weight of the alcohol solvent is 70 to 180.
<8> The dye solution for a photoelectric conversion element as described in any one of <1> to <7>,
in which the volume content ratio of the alcohol solvent in the solvent is 50% or more.
<9> The dye solution for a photoelectric conversion element as described in any one of <1> to <8>,
in which the solvent includes the alcohol solvent alone.
<10> The dye solution for a photoelectric conversion element as described in any one of <1> to <9>,
in which the alcohol solvent is the primary alcohol having 4 or more carbon atoms in total, which has at least one branched chain, or the secondary alcohol having 4 or more carbon atoms in total, which may have a branched chain.
<11> The dye solution for a photoelectric conversion element as described in any one of <1> to <10>,
in which the alcohol solvent is the primary alcohol having 4 or more carbon atoms in total, which has at least one branched chain.
<12> The dye solution for a photoelectric conversion element as described in any one of <1> to <11>,
in which the alcohol solvent is at least one selected from isobutanol, 2-methyl-1-butanol, 3-methyl-1-butanol, and 2,2-dimethyl-1-propanol.
<13> A method for producing a photoelectric conversion element, comprising contacting semiconductor fine particles with the dye solution for a photoelectric conversion element as described in any one of <1> to <12>.
<14> A kit for preparing a dye solution, formed by combination of:

a dye agent containing at least one metal complex dye represented by Formula (1); and
a liquid agent containing a solvent including at least one alcohol solvent having a molecular weight of 70 to 300, selected from a primary alcohol having 4 or more carbon atoms in total, which has at least one branched chain, a secondary alcohol having 4 or more carbon atoms in total, which may have a branched chain, and a tertiary alcohol having 5 or more carbon atoms in total, which may have a branched chain,

Formula (1) 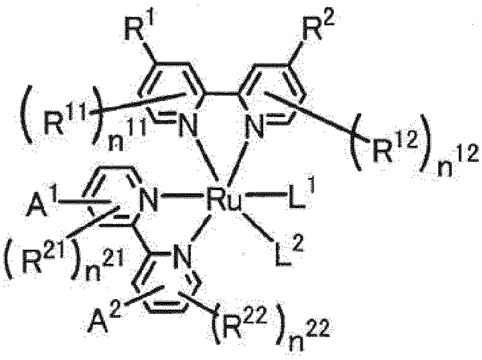

in the formula,

$R^1$ and $R^2$ each independently represent a carboxyl group or a salt thereof, an alkyl group, an ethenyl group, an ethynyl group, an aryl group, a heteroaryl group, an alkoxy group, an alkylthio group, an aryloxy group, an arylthio group, an amino group, or a monovalent group formed by combination of two or more of these groups,
$R^{11}$ and $R^{12}$ each independently represent an alkyl group, an alkenyl group, an alkoxy group, an aryl group, an alkylthio group, a heteroaryl group, an amino group, or a halogen atom, and $R^{11}$ and $R^{12}$ may be linked to each other to form a ring,
$n^{11}$ and $n^{12}$ are each independently an integer of 0 to 3,
$A^1$ and $A^2$ each independently represent an acidic group,
$R^{21}$ and $R^{22}$ each independently represent an alkyl group, an alkenyl group, an aryl group, a cyano group, a halogen atom, or an acidic group, and $R^{21}$ and $R^{22}$ may be linked to each other to form a ring,
$n^{21}$ and $n^{22}$ are each independently an integer of 0 to 3, and
$L^1$ and $L^2$ each independently represent a monodentate ligand, or $L^1$ and $L^2$ represent a bidentate ligand formed by the mutual linking thereof.

In the present specification, with regard to double bonds, unless otherwise specified, in a case where isomers in E configurations and isomers in Z configurations exist in the molecules of the double bonds, the double bonds may be either one of the two configurations or a mixture thereof.
In a case where there are a plurality of substituents, linking groups, ligands, or the like (hereinafter referred to

as substituents or the like) represented by specific symbols, or in a case where a plurality of substituents and the like are defined at the same time, the respective substituents or the like may be the same as or different from each another unless otherwise specified. This also applies to the definition of the number of substituents or the like. Further, in a case where a plurality of substituents and the like are close to each other (in particular, adjacent to each other), they may be linked to each other to form a ring unless otherwise specified. In addition, rings, for example, alicycles, aromatic rings, or heterocycles may further be fused to form a fused ring unless otherwise specified.

In the present specification, expressions of a compound (including a complex and a dye) are meant to encompass, in addition to the compound itself, salts and ions of the compound. Further, within a range exhibiting desired effects, the expressions are used to mean inclusion of modifications of a part of the structure. In addition, a compound in which substitution or non-substitution is not explicitly described is meant to indicate that compound may have an arbitrary substituent within a range exhibiting the desired effects. This also applies to substituents, linking groups, and ligands.

Moreover, in the present specification, a numerical value range represented using "(a value) to (a value)" means a range including the numerical values represented before and after "to" as a lower limit value and an upper limit value, respectively.

According to the present invention, it is possible to provide a dye solution for a photoelectric conversion element and a kit for preparing a dye solution, each of which is capable of enhancing the photoelectric conversion efficiency of a photoelectric conversion element thus obtained, even in a low-illuminance environment, and even with a shortened adsorption time, by being used in the production of the photoelectric conversion element, and a method for producing a photoelectric conversion element, using the dye solution for a photoelectric conversion element.

## BRIEF DESCRIPTION OF THE DRAWINGS

Fig. 1 is a cross-sectional view schematically showing a photoelectric conversion element in the first aspect, which is produced by the method for producing a photoelectric conversion element of the present invention, including an enlarged view of the circled portion in a layer thereof, in a system in which the photoelectric conversion element is applied in cell uses.

Fig. 2 is a cross-sectional view schematically showing a dye-sensitized solar cell including a photoelectric conversion element in the second aspect, which is produced by the method for producing a photoelectric conversion element of the present invention.

## DESCRIPTION OF THE PREFERRED EMBODIMENTS

[Dye Solution for Photoelectric Conversion Element]

The dye solution for a photoelectric conversion element of the present invention (hereinafter simply referred to as a dye solution in some cases) is a liquid composition containing at least one metal complex dye which will be described later or a solvent including at least one alcohol solvent which will be described later. Further, the dye solution may contain various additives.

In the present invention, the solution only needs to be a mixture of a solvent, a metal complex dye, and the like, and also includes a suspension, a dispersion liquid, a paste, or the like, in addition to the liquid having the metal complex dye dissolved in the solvent. Further, in the dye solution, some of the metal complex dye may be precipitated (deposited).

The dye solution for a photoelectric conversion element of the present invention is capable of enhancing the photoelectric conversion efficiency of a photoelectric conversion element thus obtained, even in a low-illuminance environment, and even with a shortened adsorption time, by being used in the production of the photoelectric conversion element.

Details of the reason are not clear but are presumed to be as follows. That is, in a case of using a dye solution for a photoelectric conversion element, containing a specific alcohol solvent which will be described later and a metal complex dye represented by Formula (1), the alcohol solvent interacts with surfaces of semiconductor fine particles. This interaction can realize a preferred state of the metal complex dye adsorbed on surfaces of semiconductor fine particles. Specifically, a hydroxyl group in the alcohol solvent interacts with the semiconductor fine particles, and thus, molecular structures having a branched structure (including a branched structure contained in a partial structure other than carbon atoms bonded to the hydroxyl group, and a branched structure in which 2 or 3 carbon chains are bonded to carbon atoms bonded to the hydroxyl group) with an appropriate length contained in the alcohol solvent inhibits the interaction between the metal complex dyes on surfaces of the semiconductor fine particles, thereby suppressing their

association or multi-layer adsorption. As a result, current leakage can be suppressed, and thus, high photoelectric conversion efficiency is exhibited in a low-illuminance environment as well as a high-illuminance environment. In addition, it is considered that the dependency of the adsorption time on the photoelectric conversion efficiency decreases.

In the present invention, examples of the high-illuminance environment and the low-illuminance environment include the above-mentioned environments, respectively. The high-illuminance environment and the low-illuminance environment cannot be uniformly determined according to purposes and the like, and are not particularly limited. For example, the high-illuminance environment can be an environment with an illuminance of more than 10,000 lux and the low-illuminance environment can be an environment with an illuminance of 10,000 lux or less.

The metal complex dye, the solvent, and the additive, each of which is used in the dye solution for a photoelectric conversion element of the present invention, will be described in order.

<Metal Complex Dye>

The metal complex dye of the present invention is represented by Formula (1).

Formula (1)

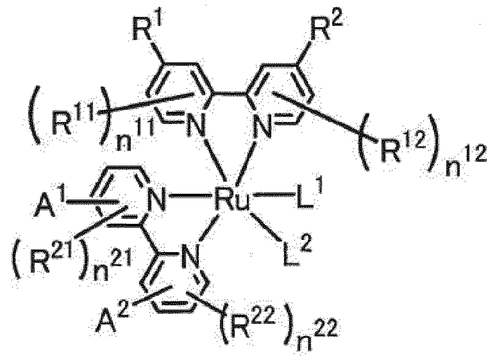

In Formula (1), $R^1$ and $R^2$ each represent a carboxyl group or a salt thereof, an alkyl group, an ethenyl group, an ethynyl group, an aryl group, a heteroaryl group, an alkoxy group, an alkylthio group, an aryloxy group, an arylthio group, an amino group, or a monovalent group formed by combination of two or more of these groups (also referred to as a composite group), and are preferably the composite group.

The carboxyl group may be in the form of a dissociated anion due to release of a proton in a case where it is included in the metal complex dye represented by Formula (1).

Examples of a salt of the carboxyl group include a salt formed of the anion of the carboxyl group and a counterion. The counterion is not particularly limited, and examples thereof include inorganic or organic ammonium ions (for example, tetraalkylammonium ions and pyridinium ions), phosphonium ions (for example, tetraalkylphosphonium ions and alkyltriphenylphosphonium ions), alkali metal ions (Li ions, Na ions, and K ions), alkaline earth metal ions, and metal complex ions. Among those, inorganic or organic ammonium ions or alkali metal ions are preferable, and organic ammonium ions (tetraethylammonium ions, tetrabutylammonium ions, tetrahexylammonium ions, tetraoctylammonium ions, tetradecylammonium ions, and the like) are more preferable.

Examples of the alkyl group which can be employed as $R^1$ and $R^2$ include a linear alkyl group, a branched alkyl group, and a cyclic(cyclo)alkyl group.

The number of carbon atoms of the linear alkyl group or branched alkyl group is preferably 1 to 30, more preferably 2 to 26, still more preferably 3 to 20, and particularly preferably 3 to 12. The number of carbon atoms of the cyclic alkyl group is preferably 3 to 30, more preferably 5 to 30, still more preferably 6 to 26, and particularly preferably 6 to 20.

Examples of the aryl group which can be employed as $R^1$ and $R^2$ include a monocyclic aromatic hydrocarbon ring group, and a ring group (a fused polycyclic aromatic hydrocarbon ring group) exhibiting aromaticity, formed by fusion of two or more monocyclic hydrocarbon rings. Examples of the monocyclic hydrocarbon ring include a monocyclic aromatic hydrocarbon ring and a hydrocarbon ring not exhibiting aromaticity, such as cyclopentadiene.

As the aryl group, a monocyclic aromatic hydrocarbon ring group is preferable.

The monocyclic aromatic hydrocarbon ring group is not particularly limited, and is preferably a benzene ring group.

The fused polycyclic aromatic hydrocarbon ring group is not particularly limited, and is preferably a group formed by fusion of at least two rings selected from a benzene ring and a cyclopentadiene ring. In the fused polycyclic aromatic hydrocarbon ring group, the number of ring members of the fused hydrocarbon ring is not particularly limited, and is preferably 4 to 8, and more preferably 5 or 6. Further, the number of the fused hydrocarbon rings is not particularly

limited, and is preferably 2 to 5, more preferably 2 or 3, and still more preferably 2. Examples of the fused polycyclic aromatic hydrocarbon ring group include the respective groups of a naphthalene ring, an anthracene ring, a phenanthrene ring, a triphenylene ring, a chrysene ring, a picene ring, a pyrene ring, a fluorene ring, and an azulene ring.

The number of ring-constituting atoms of the aryl group which can be employed as $R^1$ and $R^2$ is not particularly limited, and is preferably 6 to 30, more preferably 6 to 15, and still more preferably 6 to 13.

Examples of the heteroaryl group which can be employed as $R^1$ and $R^2$ include a monocyclic aromatic heterocyclic group, and a ring group (a fused polycyclic aromatic heterocyclic group) exhibiting aromaticity, formed by fusion of a plurality of monocycles (including monocycles not exhibiting aromaticity) including a heterocycle. Examples of the monocycles forming the fused polycyclic aromatic heterocyclic group include a monocyclic aromatic heterocycle and a monocyclic hydrocarbon ring. The monocyclic hydrocarbon ring has the same definition as the monocyclic hydrocarbon ring in the aryl group.

As the heteroaryl group, a monocyclic aromatic heterocyclic group is preferable.

The monocyclic aromatic heterocyclic group is not particularly limited, and is preferably an aromatic heterocyclic group having a carbon atom and at least one heteroatom (for example, a nitrogen atom, an oxygen atom, a sulfur atom, a silicon atom, a selenium atom, and a phosphorus atom) as a ring-constituting atom. The monocyclic aromatic heterocyclic group is not particularly limited, and is preferably a 5- or 6-membered ring group.

Examples of the monocyclic aromatic heterocyclic group include the respective groups of a thiophene ring, a furan ring, a pyrrole ring, a selenophene ring, a thiazole ring, an oxazole ring, an isothiazole ring, an isoxazole ring, an imidazole ring, a pyrazole ring, a thiadiazole ring, an oxadiazole ring, a triazole ring, a silole ring, a phosphole ring, a pyridine ring, a pyrazine ring, a pyrimidine ring, a pyridazine ring, a triazine ring, and a tetrazine ring, and the monocyclic aromatic heterocyclic group is preferably each group of the thiophene ring and the furan ring, and more preferably the thiophene ring group.

The fused polycyclic aromatic heterocyclic group is not particularly limited, and examples thereof include a ring group in which a monocyclic aromatic heterocyclic group is bonded to a pyridine ring in Formula (1). Examples thereof include a ring group formed by fusion of a plurality of monocyclic aromatic heterocycles, and a ring group formed by fusion of a monocyclic aromatic heterocycle and a plurality of monocyclic hydrocarbon rings. In the fused polycyclic aromatic heterocyclic group, the number of ring members of the fused monocycles and the number of the monocycles are not particularly limited, and have the same number of ring members of the fused hydrocarbon ring and the same number of the hydrocarbon rings as in the fused polycyclic aromatic hydrocarbon ring group, and preferred ranges thereof are also the same.

Examples of the fused polycyclic aromatic heterocyclic group include the respective groups of a benzofuran ring, an isobenzofuran ring, a benzothiophene ring, a benzoisothiophene ring, an indazole ring, an indole ring, an isoindole ring, an indolizine ring, a carbazole ring (dibenzopyrrole ring), a quinoline ring, an isoquinoline ring, a benzoxazole ring, a benzoisoxazole ring, a benzothiazole ring, a benzoisothiazole ring, a benzoimidazole ring, a benzotriazole ring, a dibenzofuran ring, a dibenzothiophene ring, a thienopyridine ring, a silafluorene ring (dibenzosilole ring), a thienothiophene ring, a trithiophene ring, a cyclopentadithiophene ring, a cyclopentadifuran ring, a benzodifuran ring, a benzodithiophene ring, a dithienopyrrole ring, a dithienofuran ring, and a dithienosilole ring.

The number of ring-constituting carbon atoms of the heteroaryl group which can be employed as $R^1$ and $R^2$ is not particularly limited, and is preferably 0 to 24, and more preferably 1 to 18.

Examples of the alkoxy group which can be employed as $R^1$ and $R^2$ include a linear alkoxy group, a branched alkoxy group, and a cyclic (cyclo) alkoxy group. The alkyl moiety of the alkoxy group has the same definition as that of the alkyl group, and preferred examples thereof are also the same. The number of carbon atoms in the alkoxy group is preferably 1 to 30, more preferably 2 to 26, still more preferably 3 to 20, and particularly preferably 3 to 12.

Examples of the alkylthio group which can be employed as $R^1$ and $R^2$ include a linear alkylthio group, a branched alkylthio group, and a cyclic (cyclo) alkylthio group. The alkyl moiety of the alkylthio group has the same definition as that of the alkyl group, and preferred examples thereof are also the same. The number of carbon atoms in the alkylthio group is preferably 1 to 30, more preferably 2 to 26, still more preferably 3 to 20, and particularly preferably 3 to 12.

Examples of the aryloxy group which can be employed as $R^1$ and $R^2$ include a heteroaryloxy group, in addition to an aromatic hydrocarbon ring oxy group. The aromatic hydrocarbon ring group in the aryloxy group has the same definition as the aryl group which can be employed as $R^1$ and $R^2$ (which is the same in the arylthio group). Further, the heteroaryl ring group in the aryloxy group has the same definition as the heteroaryl group which can be employed as $R^1$ and $R^2$ (which is the same in the arylthio group). The number of carbon atoms of the aryloxy group is preferably 3 to 30, more preferably 3 to 25, still more preferably 3 to 20, and particularly preferably 3 to 16.

The arylthio group which can be employed as $R^1$ and $R^2$ includes a heteroarylthio group, in addition to an aromatic hydrocarbon ring thio group. The number of carbon atoms of the arylthio group is preferably is preferably 3 to 30, more preferably 3 to 25, still more preferably 3 to 20, and particularly preferably 3 to 16.

Examples of the amino group which can be employed as $R^1$ and $R^2$ include an alkylamino group, an arylamino group, and a heteroarylamino group, in addition to an unsubstituted amino group ($-NH_2$).

Examples of the arylamino group include an N-alkylamino group and N,N-dialkylamino group. Further, examples of the arylamino group include an N-arylamino group, an N-alkyl-N-arylamino group, and N,N-diarylamino group. Examples of the heteroarylamino group include an N-heteroarylamino group, an N-alkyl-N-heteroarylamino group, an N-aryl-N-heteroarylamino group, and an N,N-diheteroarylamino group.

As the amino group, an N,N-dialkylamino group or an N,N-diarylamino group is preferable and the N,N-diarylamino group is more preferable.

The alkyl group, the aryl group, and the heteroaryl group contained at the nitrogen atom in the amino group is not particularly limited, and have the same definitions as the alkyl group, the aryl group, and the heteroaryl group which can be employed as $R^1$ and $R^2$, and preferred ranges thereof are also the same.

The amino group which can be employed as $R^1$ and $R^2$ may or may not have a substituent as will be described later, and preferably has the substituent. The substituent is not particularly limited, and examples thereof include the respective groups which can be employed as $R^1$ and $R^2$, or groups other than the groups among the groups selected from a substituent group T which will be described later. Among those, the alkyl group, the aryl group, the heteroaryl group, the alkoxy group, the aryloxy group, the alkylthio group, the arylthio group, the amino group, the halogen atom, or the cyano group is preferable, the alkyl group, the aryl group, the heteroaryl group, the alkoxy group, the alkylthio group, the amino group, or the halogen atom is more preferable, the alkyl group, the aryl group, the alkoxy group, the alkylthio group, the amino group, or the halogen atom is still more preferable, the alkyl group, the alkoxy group, the alkylthio group, or the amino group is particularly preferable, and the alkyl group is the most preferable.

In a case where the amino group has a substituent, the number of the substituents is not particularly limited, and is preferably 1 to 4, and more preferably 1 or 2 in total. In a case where the amino group has a plurality of substituents, these substituents may be the same as or different from each other.

In a case where the amino group has a substituent, the position which is substituted with the substituent is not particularly limited. For example, in a case where an amino group contained in the aryl group bonded to the nitrogen atom has a substituent in the aryl group, the position may be any one of a 2-position (ortho-position), a 3-position (meta-position), and a 4-position (para-position) with respect to a ring-constituting atom bonded to the nitrogen atom of the aryl group, and is preferably the 3- or 4-position, and more preferably the 4-position. In a case where the aryl group has two substituents, the substitution positions are preferably 2- and 4-positions, respectively, or both 3-positions.

In a case where the amino group has two alkyl groups or (hetero)aryl groups bonded to the nitrogen atom, the two alkyl or (hetero)aryl groups may be bonded to each other directly or via a linking group. Such a linking group is not particularly limited, and examples thereof include -O-, -S-, $-NR^{NR}-$, $-C(R^{NR})_2-$, and $-Si(R^{NR})_2-$. Here, examples of $R^{NR}$ include a group selected from the substituent group T, and preferably an alkyl group.

Examples of the amino group which can be employed as $R^1$ and $R^2$ include N,N-dialkylamino, N,N-diarylamino, N,N-di(4-alkylphenyl)amino, and N,N-di(4-alkoxyphenyl)amino. Specific examples thereof include N,N-diethylamino, N,N-dihexylamino, N,N-diphenylamino, N,N-dinaphthylamino, N,N-phenylnaphthylamino, N,N-diphenylfluorenylamino, 9-carbazolyl, N,N-di(4-(n-butyl)phenyl)amino, N,N-di(4-(t-butyl)phenyl)amino, N,N-di(4-(n-hexyl)phenyl)amino, N,N-di(4-(n-octyloxy)phenyl)amino, and N,N-di(4-(n-hexyl)thienyl)amino.

In a case where each of the groups is singly used as $R^1$ and $R^2$, the group is preferably a carboxyl group or a salt thereof, an alkyl group, an aryl group, a heteroaryl group, an alkoxy group, an alkylthio group, or an amino group, more preferably a carboxyl group or a salt thereof, an alkyl group, an alkoxy group, an alkylthio group, or an amino group, and still more preferably an alkyl group, an alkoxy group, an alkylthio group, or an amino group.

Preferred examples of the monovalent group which can be employed as $R^1$ and $R^2$ include a monovalent composite group formed by combination of two or more groups selected from the group consisting of the alkyl group, the ethenyl group, the ethynyl group, the aryl group, the heteroaryl group, the alkoxy group, the alkylthio group, the aryloxy group, the arylthio group, and the amino group as mentioned above. Here, the composite group formed by combination of the groups refers to a monovalent group formed by substituting a hydrogen atom contained in the group selected from the group with another group. For example, in a case of an arylethenyl group, the composite group is intended to be a group formed by substituting a hydrogen atom of an ethenyl group selected from the group with an aryl group.

In the composite group, the number of groups to be combined is not particularly limited as long as it is 2 or more, and is, for example, preferably 2 to 10, more preferably 2 to 6, and still more preferably 2 to 5.

The combination of the groups is not particularly limited, and a combination of a pyridine ring bonded to $R^1$ or $R^2$ and a group capable of forming a conjugated system is preferable.

Examples of the group capable of forming a conjugated system include an ethenyl group, an ethynyl group, an aryl group, a heteroaryl group, or a group formed with two or more thereof. Specific examples of the group formed with two or more thereof include a group formed by combination of an ethenyl group or an ethynyl group with an aryl group or a heteroaryl group, or a group formed by combination of aryl groups or heteroaryl groups alone.

As the combination of the groups in the composite group, for example, a combination only of groups capable of forming a conjugated system (a group formed with two or more of the above-mentioned groups), or a combination of

a group capable of forming a conjugated system with at least one of an alkyl group, an alkoxy group, an alkylthio group, an aryloxy group, an arylthio group, or an amino group, is preferable, a combination of a group capable of forming a conjugated system with at least one of an alkyl group, an alkoxy group, an alkylthio group, or an amino group is more preferable, and a combination of a group capable of forming a conjugated system with an amino group or a combination of a group capable of forming a conjugated system, an amino group, and an alkyl group is still more preferable.

The respective groups included in the group have the same definitions as those mentioned above as the group which can be employed as $R^1$ and $R^2$, included in the group, and a preferred range thereof is also the same.

$R^1$ and $R^2$ may each have a substituent. Such a substituent is not particularly limited, and examples thereof include groups other than the groups which can be employed as $R^1$ and $R^2$ among the groups selected from the substituent group T which will be described later. For example, in a case of employing an alkyl group as $R^1$ and $R^2$, as the substituent, a halogen atom is preferable, and a fluorine atom is more preferable.

In Formula (1), $R^{11}$ and $R^{12}$ each represent an alkyl group, an alkenyl group, an alkoxy group, an aryl group, an alkylthio group, a heteroaryl group, an amino group, or a halogen atom.

The alkyl group, the alkoxy group, the aryl group, the alkylthio group, the heteroaryl group, and the amino group which can be employed as $R^{11}$ and $R^{12}$ each have the same definitions as the alkyl group, the alkoxy group, the aryl group, the alkylthio group, the heteroaryl group, and the amino group which can be employed as $R^1$ and $R^2$, and preferred ranges thereof are also the same.

The alkenyl group which can be employed as $R^{11}$ and $R^{12}$ is not particularly limited, and examples thereof include the alkenyl groups in the substituent group T which will be described later.

Examples of the halogen atom which can be employed as $R^{11}$ and $R^{12}$ include a fluorine atom, a chlorine atom, a bromine atom, and an iodine atom. Among those, the chlorine atom or the bromine atom is preferable.

$R^{11}$ and $R^{12}$ may be linked to each other to form a ring. An aspect for linking $R^{11}$ and $R^{12}$ is not particularly limited, and the following aspects are included. For example, an aspect in which $R^{11}$'s or $R^{12}$'s are bonded to each other to form a ring (fused ring) together with a pyridine ring to which $R^{11}$ or $R^{12}$ is bonded, and an aspect in which $R^{11}$ and $R^{12}$ are linked to each other to form a ring (fused ring) together with two pyridine rings to which $R^{11}$ and $R^{12}$ are bonded (including a form in which $R^{11}$ or $R^{12}$ is bonded to two pyridine rings to form a ring) are included.

In a case where a plurality of $R^{11}$'s and $R^{12}$'s are present, the plurality of $R^{11}$'s and $R^{12}$'s may be the same as or different from each other. Further, in a case where a plurality of $R^{11}$'s or $R^{12}$'s are present, and some of $R^{11}$'s or $R^{12}$'s form a ring, the rest of $R^{11}$'s or $R^{12}$'s may be bonded to a pyridine ring or bonded to a ring formed by $R^{11}$ or $R^{12}$.

$R^{11}$ and $R^{12}$ may each have a substituent. Examples of such a substituent include groups selected from the substituent group T which will be described later.

The position of each pyridine ring to which $R^{11}$ and $R^{12}$ are bonded is not particularly limited.

$n^{11}$ and $n^{12}$ are each an integer of 0 to 3, preferably an integer of 0 to 2, more preferably 0 or 1, and still more preferably 0.

In Formula (1), $A^1$ and $A^2$ each represent an acidic group.

In the present invention, the acidic group is a substituent which has a dissociative proton and has a pKa of 11 or less. The pKa of the acidic group can be determined in accordance with the "SMD/M05-2X/6-31G*" method described in J. Phys. Chem. A2011, 115, pp. 6641-6645. Examples of the acidic group include an acid group showing acidity, such as a carboxyl group, a phosphonyl group, a phosphoryl group, a sulfo group, a boric acid group, a phenolic hydroxyl group, and a sulfonamido group; and groups having these acid groups. Examples of the group having an acid group include groups having an acid group and a linking group. The linking group is not particularly limited, and examples thereof include a divalent group, and preferably an alkylene group, an alkenylene group, an alkynylene group, an arylene group, and a heteroarylene group. This linking group may have a group selected from the substituent group T which will be described later as a substituent. Preferred examples of the acidic group having an acid group and a linking group include carboxymethyl, carboxyvinylene, dicarboxyvinylene, cyanocarboxyvinylene, 2-carboxy-1-propenyl, 2-carboxy-1-butenyl, and carboxyphenyl.

The acidic group is preferably an acidic group contained in an exemplary compound which will be described later, more preferably a carboxyl group, a phosphonyl group, a sulfo group, or a group having a carboxyl group, and still more preferably a carboxyl group.

In a case where the acidic group is included in the metal complex dye represented by Formula (1), it may become a dissociated anion due to release of a proton or may become a salt. The counterion in a case where the acidic group becomes a salt is not particularly limited, and examples thereof include the above-mentioned counterions.

$A^1$ and $A^2$ may be the same as or different from each other.

The position of the pyridine ring to which $A^1$ and $A^2$ are bonded is not particularly limited. For example, the position in each pyridine ring of the bipyridine ligand is preferably a ring-constituting carbon atom at the 3- to 6-position, more preferably a ring-constituting carbon atom at the 4- or 5-position, and still preferably a ring-constituting carbon atom at the 4-position in a case where the carbon atom bonded to the other pyridine ring is at the 2-position with respect to the ring-constituting nitrogen atom (1-position) coordinating to Ru.

$R^{21}$ and $R^{22}$ each represent an alkyl group, an alkenyl group, an aryl group, a cyano group, a halogen atom, or an acidic group.

The alkyl group and the aryl group which can be employed as $R^{21}$ and $R^{22}$ each have the same definitions as the alkyl group and the aryl group which can be employed as $R^1$ and $R^2$, and preferred ranges thereof are also the same.

The alkenyl group which can be employed as $R^{21}$ and $R^{22}$ is not particularly limited, and examples thereof include the alkenyl groups in the substituent group T which will be described later.

Examples of the halogen atom which can be employed as $R^{21}$ and $R^{22}$ include a fluorine atom, a chlorine atom, a bromine atom, and an iodine atom. Among those, the chlorine atom or the bromine atom is preferable.

The acidic group which can be employed as $R^{21}$ and $R^{22}$ has the same definition as the above-mentioned acidic group, a preferred range thereof is also the same.

$R^{21}$ and $R^{22}$ may be linked to each other to form a ring.

The aspect for linking $R^{21}$ and $R^{22}$ is not particularly limited, and the following forms are included. For example, a form in which $R^{21}$'s or $R^{22}$'s are linked to each other to form a ring (fused ring) together with a pyridine ring to which $R^{21}$ or $R^{22}$ is bonded, a form in which $R^{21}$ and $R^{22}$ are linked to each other to form a ring (fused ring) together with two pyridine rings to which $R^{21}$ and $R^{22}$ are bonded (including a form in which $R^{21}$ or $R^{22}$ is bonded to two pyridine rings to form a ring), and a form with a combination thereof.

In a case where $R^{21}$ and $R^{22}$ are linked to each other to form a ring, the chemical structure bipyridine ligand contained in $R^{21}$ and $R^{22}$ is not particularly limited. For example, examples of the form in which $R^{21}$'s or $R^{22}$'s are linked to each other include exemplary compounds B-5-1 to B-5-6 or B-7-1 to B-7-6 which will be described later. Further, examples of the form in which $R^{21}$ and $R^{22}$ are linked to each other include exemplary compounds B-3-1 to B-3-6 or B-4-1 to B-4-6 which will be described later. In addition, examples of the form with a combination thereof include exemplary compounds B-6-1 to B-6-6, B-8-1 to B-8-6, and B-9-1 to B-9-6 which will be described later.

In a case where a plurality of $R^{21}$'s and $R^{22}$'s are present, the plurality of $R^{21}$'s and $R^{22}$'s may be the same as or different from each other. Further, in a case where a plurality of $R^{21}$'s or $R^{22}$'s are present, and some of $R^{21}$'s or $R^{22}$'s form a ring, the rest of $R^{21}$'s or $R^{22}$'s may be bonded to a pyridine ring or bonded to a ring formed by $R^{21}$ or $R^{22}$.

$R^{21}$ and $R^{22}$ may each have a substituent. Examples of such a substituent include groups selected from the substituent group T which will be described later. As the substituent, a halogen atom is preferable, and a fluorine atom is more preferable.

The position of each pyridine ring to which $R^{21}$ and $R^{22}$ are bonded is not particularly limited. For example, the position in each pyridine ring of the bipyridine ligand is preferably a ring-constituting carbon atom at the 3- to 6-position, and more preferably a ring-constituting carbon atom at the 3-, 5-, or 6-position, in a case where the carbon atom bonded to the other pyridine ring is at the 2-position with respect to the ring-constituting nitrogen atom (1-position) coordinating to Ru.

$n^{21}$ and $n^{22}$ are each an integer of 0 to 3, preferably an integer of 0 to 2, more preferably 0 or 1, and still more preferably 0.

$L^1$ and $L^2$ each represent a monodentate ligand or $L^1$ and $L^2$ represent a bidentate ligand formed by the mutual linking thereof, with the monodentate ligand being preferable.

$L^1$ and $L^2$ are not particularly limited, and examples thereof include a ligand (hereinafter also referred to as a XXX group) that coordinates at a group selected from the group consisting of an acyloxy group, a thioacylthio group, an acylaminooxy group, a dithiocarbamate group, a dithiocarbonate group, a trithiocarbonate group, a thiocyanate group, an isothiocyanate group, an isoselenocyanate group, a cyanate group, an isocyanate group, a cyano group, an alkylthio group, an arylthio group, an alkoxy group, and an aryloxy group, or a ligand including a halogen atom, carbonyl, a 1,3-diketone, or a thiourea.

$L^1$ and $L^2$ are preferably an acyloxy group, an acylaminooxy group, a dithiocarbamate group, a thiocyanate group, an isothiocyanate group, a cyanate group, an isocyanate group, a cyano group, an arylthio group, a halogen atom, 1,3-diketone, or thiourea, more preferably a dithiocarbamate group, a thiocyanate group, an isothiocyanate group, a cyanate group, an isocyanate group, a halogen atom, or a 1,3-diketone, and particularly preferably a dithiocarbamate group, a thiocyanate group, an isothiocyanate group, or a 1,3-diketone.

In a case where $L^1$ and $L^2$ include an alkyl group, an alkenyl group, an alkynyl group, an alkylene group, or the like, these groups may be linear or branched, and may be substituted or unsubstituted. Further, in a case where $L^1$ and $L^2$ include an aryl group, a heterocyclic group, a cycloalkyl group, or the like, these groups may be substituted or unsubstituted, and may be a monocycle or a fused ring.

In the case where $L^1$ and $L^2$ are a bidentate ligand formed by the mutual linking thereof, $L^1$ and $L^2$ are each preferably an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, an alkylthio group, an arylthio group, an alkoxy group, an aryloxy group, a 1,3-diketone, a carbonamide, a thiocarbonamide, or a thiourea.

In a case where $L^1$ and $L^2$ are each a monodentate ligand, $L^1$ and $L^2$ are preferably an isothiocyanate group,

a thiocyanate group, an isoselenocyanate group, an isocyanate group, a cyanate group, a cyano group, an alkylthio group, an arylthio group, an alkoxy group, an aryloxy group, a halogen atom, carbonyl, a dialkylketone, or a thiourea, more preferably an isothiocyanate group, a thiocyanate group, an isoselenocyanate group, an isocyanate group, a cyanate group, a cyano group, an alkylthio group, an arylthio group, an alkoxy group, an aryloxy group, or a halogen atom, and still more preferably an isothiocyanate group, a thiocyanate group, an isocyanate group, a cyanate group, or a cyano group.

As the 1,3-diketone, those shown below are preferable.

In the following examples, Me represents methyl, and * represents a binding site to carbonyl carbon.

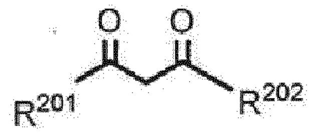

| | $R^{201}$ | $R^{202}$ |
|---|---|---|
| C-1-1 | Me | Me |
| C-1-2 | $CF_3$ | $CF_3$ |
| C-1-3 | 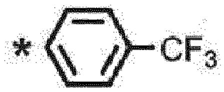 | $CF_3$ |
| C-1-4 | 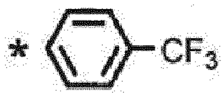 | 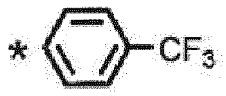 |
| C-1-5 | 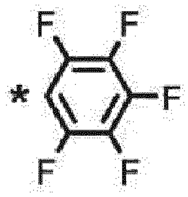 | 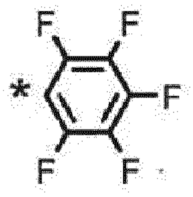 |

The metal complex dye used in the present invention is preferably represented by Formula (2).

Formula (2)

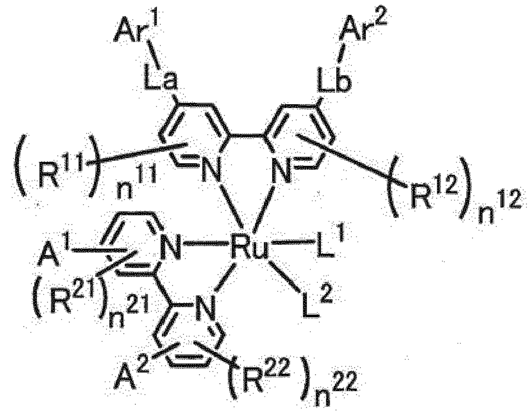

In Formula (2), $R^{11}$, $R^{12}$, $n^{11}$, $n^{12}$, $A^1$, $A^2$, $R^{21}$, $R^{22}$, $n^{21}$, $n^{22}$, $L^1$, and $L^2$ have the same definitions as those in Formula (1), respectively, and preferred ranges thereof are also the same.

La and Lb each represent a single bond, or a conjugated linking group selected from an ethenylene group, an ethynylene group, an arylene group, and a heteroarylene group, and are preferably the conjugated linking group selected from an ethenylene group, an ethynylene group, an arylene group, and a heteroarylene group.

In a case where La or Lb is a conjugated linking group, -La-$Ar^1$ and -Lb-$Ar^2$ in Formula (2) each correspond to

the above-mentioned group capable of forming a conjugated system in $R^1$ and $R^2$ of Formula (1).

Examples of the conjugated linking group which can be employed as La and Lb include an ethenylene group, an ethynylene group, an arylene group, and a heteroarylene group.

Examples of the ethenylene group, the ethynylene group, the arylene group, and the heteroarylene group include groups formed by further removing one hydrogen atom from each group of an ethenyl group, an ethynyl group, an aryl group, and a heteroaryl group which can be employed as $R^1$ and $R^2$.

As the conjugated linking group, an ethenylene group, an ethynylene group, a phenylene group, a furanyl group, or a thienyl group is preferable, and an ethenylene group is more preferable.

$Ar^1$ and $Ar^2$ each represent an aryl group or a heteroaryl group, and are each preferably an aryl group, and more preferably a phenyl group.

Examples of the aryl group and the heteroaryl group which can be employed as $Ar^1$ and $Ar^2$ have the same definitions as the aryl group and the heteroaryl group which can be employed as $R^1$ and $R^2$, and preferred ranges thereof are also the same.

$Ar^1$ and $Ar^2$ may each have a substituent. As such a substituent which can be employed as $Ar^1$ and $Ar^2$, the respective groups which can be employed as $R^1$ and $R^2$ are preferable, and among those, an alkyl group, an alkoxy group, an alkylthio group, an aryloxy group, an arylthio group, an ethynyl group, or an amino group is more preferable, an alkyl group, an alkoxy group, an alkylthio group, or an amino group is still more preferable, and an amino group is particularly preferable. In addition, substituents other than those can be used as the substituent, and examples of such other substituents include groups other than the groups which can be employed as $R^1$ and $R^2$ among the groups selected from a substituent group T which will be described later.

In a case where $Ar^1$ and $Ar^2$ each have a substituent, the number of the substituents is not particularly limited, and is preferably 1 or 2, and more preferably 1. In a case where $Ar^1$ and $Ar^2$ have a plurality of substituents, these substituents may be the same as or different from each other.

In a case where $Ar^1$ and $Ar^2$ each have a substituent, the substitution position is not particularly limited. For example, in $Ar^1$ and $Ar^2$, the substitution position is preferably the 2-position (adjacent position) to 4-position with respect to the ring-constituting atom bonded to La and Lb. In a case where $Ar^1$ and $Ar^2$ are each a 6-membered ring, the substitution position is more preferably the 3- or 4-position, and still more preferably the 4-position. In a case where $Ar^1$ and $Ar^2$ are each a 5-membered ring, the substitution position is more preferably the 2- or 3-position.

The metal complex dye used in the present invention is preferably represented by Formula (3).

Formula (3)

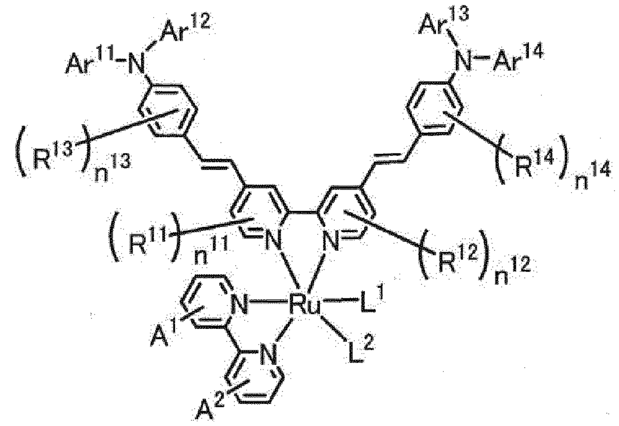

In Formula (3), $R^{11}$, $R^{12}$, $n^{11}$, $n^{12}$, $A^1$, $A^2$, $L^1$, and $L^2$ have the same definitions as those in Formula (1), respectively, and preferred ranges thereof are also the same.

$Ar^{11}$ to $Ar^{14}$ each represent an aryl group or a heteroaryl group, and are preferably an aryl group.

The aryl group and the heteroaryl group which can be employed as $Ar^{11}$ to $Ar^{14}$ have the same definitions as the aryl group and the heteroaryl group which can be employed as $R^1$ and $R^2$, respectively, and preferred ranges thereof are also the same.

In Formula (3), the amino group, $-N(Ar^{11})(Ar^{12})$, and $-N(Ar^{13})(Ar^{14})$ each have the same definitions as the amino group (an N,N-diarylamino group, an N,N-diheteroarylamino group, and an N-aryl-N-heteroarylamino group) which can be employed as $R^1$ and $R^2$, and preferred ranges thereof are also the same. That is, $Ar^{11}$ to $Ar^{14}$ may each have a substituent. Examples of the substituent include the substituents which the amino group which can be employed as $R^1$ and $R^2$ may have.

$R^{13}$ and $R^{14}$ each represent an alkyl group, an alkoxy group, an aryl group, an alkylthio group, a heteroaryl group, an amino group, or a halogen atom. Among those, the alkyl group, the alkoxy group, or the amino group is

preferable.

The alkyl group, the alkoxy group, the aryl group, the alkylthio group, the heteroaryl group, and the amino group which can be employed as $R^{13}$ and $R^{14}$ have the same definitions as the alkyl group, the alkoxy group, the aryl group, the alkylthio group, a heteroaryl group, and the amino group which can be employed as $R^1$ and $R^2$, respectively, and preferred ranges thereof are also the same.

The halogen atom which can be employed as $R^{13}$ and $R^{14}$ has the same definitions as the halogen atom which can be employed as $R^{11}$ and $R^{12}$, and a preferred range thereof is also the same.

In a case where a plurality of $R^{13}$'s and $R^{14}$'s are present, the plurality of $R^{13}$'s and $R^{14}$'s may be the same as or different from each other. Further, $R^{13}$'s or $R^{14}$'s may be linked to each other to form a ring (fused ring) together with a benzene ring to which $R^{13}$ or $R^{14}$ is bonded.

$R^{13}$ and $R^{14}$ may each have a substituent. Examples of such a substituent include groups selected from the substituent group T which will be described later.

The position of the benzene ring group to which $R^{13}$ and $R^{14}$ are bonded is not particularly limited. For example, the position is, for example, a ring-constituting carbon atom at the 2- or 3-position with respect to the ring-constituting carbon atom bonded to an ethenylene group.

$n^{13}$ and $n^{14}$ are each an integer of 0 to 4, preferably an integer of 0 to 2, more preferably 0 or 1, and still more preferably 0.

The metal complex dye can be synthesized by, for example, the methods described in JP2013-072079A or JP2001-291534A, the patent publications regarding solar cells, common methods, or the methods equivalent thereto.

The metal complex dye has a maximum absorption wavelength in a solution, which is preferably in a range of 300 to 1,000 nm, more preferably in a range of 350 to 950 nm, and particularly preferably in a range of 370 to 900 nm.

<Substituent Group T>

In the present invention, preferred examples of the substituent include groups selected from the following substituent group T. The substituent group T does not include the above-mentioned acidic groups.

Furthermore, in this specification, in a case where only a substituent is simply listed, reference is made to the substituent group T, and in a case where each of the groups, for example, an alkyl group is singly described, preferred ranges and specific examples of the corresponding groups of the substituent group T are applied.

In the present invention, in a case where a group is capable of forming a non-cyclic skeleton and a cyclic skeleton, this group includes a group with a non-cyclic skeleton and a group with a cyclic skeleton unless otherwise specified. For example, examples of the alkyl group include a linear alkyl group, a branched alkyl group, and a cyclic(cyclo) alkyl group. In a case where the group is capable of forming a cyclic skeleton, the lower limit of the number of atoms in a group forming a cyclic skeleton is 3 or more, and preferably 5 or more, irrespective of the lower limit of the number of atoms specifically described for the group.

In addition, in the description of the following substituent group T, in order to clarify a group with a linear or branched structure and a group with a cyclic structure, for example, as in the alkyl group and the cycloalkyl group, the both groups are separately described.

Examples of the groups included in the substituent group T include the following groups and the groups formed by the combination of a plurality of the following groups:

an alkyl group (preferably having 1 to 20 carbon atoms, and more preferably having 1 to 12 carbon atoms), an alkenyl group (preferably having 2 to 20 carbon atoms, and more preferably having 2 to 12 carbon atoms), an alkynyl group (preferably having 2 to 20 carbon atoms, and more preferably having 2 to 12 carbon atoms), a cycloalkyl group (preferably having 3 to 20 carbon atoms), a cycloalkenyl group (preferably having 5 to 20 carbon atoms), an aryl group (an aromatic hydrocarbon ring group, preferably having 6 to 26 carbon atoms), a heterocyclic group (which has at least one oxygen atom, sulfur atom, or nitrogen atom as a ring-constituting atom, and preferably has 2 to 20 carbon atoms, and is more preferably a 5- or 6-membered ring. Examples of the heterocyclic group include an aromatic heterocyclic group (also referred to as a heteroaryl group), an aliphatic heterocyclic group, an alkoxy group (preferably having 1 to 20 carbon atoms, and more preferably having 1 to 12 carbon atoms), an alkenyloxy group (preferably having 2 to 20 carbon atoms, and more preferably having 2 to 12 carbon atoms), an alkynyloxy group (preferably having 2 to 20 carbon atoms, and more preferably having 2 to 12 carbon atoms), a cycloalkyloxy group (preferably having 3 to 20 carbon atoms), an aryloxy group (preferably having 6 to 26 carbon atoms), a heterocyclic oxy group (preferably having 2 to 20 carbon atoms).

an alkoxycarbonyl group (preferably having 2 to 20 carbon atoms), a cycloalkoxycarbonyl group (preferably having 4 to 20 carbon atoms), an aryloxycarbonyl group (preferably having 6 to 20 carbon atoms), an amino group (preferably having 0 to 20 carbon atoms, and including an alkylamino group, an alkenylamino group, an alkynylamino group, a cycloalkylamino group, a cycloalkenylamino group, an arylamino group, and a heterocyclic amino group), a sulfamoyl group (preferably having 0 to 20 carbon atoms, and being preferably an alkyl-, cycloalkyl-, or aryl-sulfamoyl group), an acyl group (preferably having 1 to 20 carbon atoms), an acyloxy group (preferably having 1 to 20 carbon atoms), a carbamoyl group (preferably having 1 to 20 carbon atoms, being preferably an alkyl-, cycloalkyl-, or aryl-carbamoyl group, and including, for example, N,N-dimethylcarbamoyl, N-cyclohexylcarbamoyl, and N-phenylcarbamoyl),

an acylamino group (preferably having 1 to 20 carbon atoms), a sulfonamido group (preferably having 0 to 20 carbon atoms, and being preferably an alkyl-, cycloalkyl-, or aryl-sulfonamido group), an alkylthio group (preferably having 1 to 20 carbon atoms, and more preferably having 1 to 12 carbon atoms), a cycloalkylthio group (preferably having 3 to 20 carbon atoms), an arylthio group (preferably having 6 to 26 carbon atoms), a heterocyclic thio group (preferably having 2 to 20 carbon atoms), an alkyl-, cycloalkyl-, or aryl-sulfonyl group (preferably having 1 to 20 carbon atoms), a silyl group (preferably having 1 to 20 carbon atoms, and being preferably an alkyl-, aryl-, alkoxy-, or aryloxy-substituted silyl group), a silyloxy group (preferably having 1 to 20 carbon atoms, and being preferably an alkyl-, aryl-, alkoxy-, or aryloxy-substituted silyloxy group), a hydroxyl group, a cyano group, a nitro group, and a halogen atom (for example, a fluorine atom, a chlorine atom, a bromine atom, and an iodine atom).

The group selected from the substituent group T is more preferably an alkyl group, an alkenyl group, a cycloalkyl group, an aryl group, a heterocyclic group, an alkoxy group, a cycloalkoxy group, an aryloxy group, an alkoxycarbonyl group, a cycloalkoxycarbonyl group, an amino group, an acylamino group, a cyano group, or a halogen atom, and particularly preferably an alkyl group, an alkenyl group, a heterocyclic group, an alkoxy group, an alkoxycarbonyl group, an amino group, an acylamino group, or a cyano group.

In the present invention, in a case where the compound, the substituent, or the like includes an alkyl group, an alkenyl group, or the like, these may be substituted or unsubstituted. Examples of the alkyl group which may be substituted include a halogenated alkyl group. In addition, when the compound, the substituent, or the like includes an aryl group, a heterocyclic group, or the like, these may be a monocycle or a fused ring, and may be substituted or unsubstituted.

Specific examples of the respective ligands contained in the metal complex dye are shown below and Examples.

In the following specific examples, the ligand having $A^1$ and $A^2$ in Formula (1) is referred to as an acceptor ligand, and ligand contained in $R^1$ and $R^2$ is referred to as an auxiliary ligand. Further, Et represents ethyl and * represents a binding site.

Specific examples of the metal complex dye include metal complex dyes formed by appropriately combining the respective ligands shown below. With respect to specific preferred examples of the metal complex dye, reference can be appropriately made to metal complex dyes described in the combinations with alcohol solvent in Table 1 which will be described later.

Furthermore, the following specific examples may also include ligands and metal complex dyes in which at least one of carboxyl groups is a salt of the carboxyl group. In these ligands and metal complex dyes, examples of a counteraction that forms a salt of the carboxyl group include the above-mentioned counterions.

The present invention is not limited to these ligands and metal complex dyes.

First, specific examples of the auxiliary ligand will be shown.

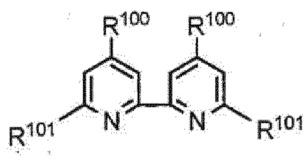

| | $R^{100}$ | $R^{101}$ |
|---|---|---|
| A-1-1 | $-CO_2H$ | H |
| A-1-2 | 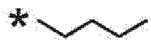 | H |
| A-1-3 | 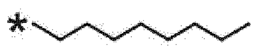 | |
| A-1-4 | 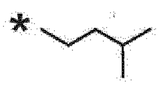 | H |
| A-1-5 | 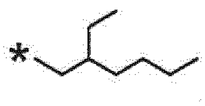 | H |

(continued)

| | $R^{100}$ | $R^{101}$ |
|---|---|---|
| A-1-6 | 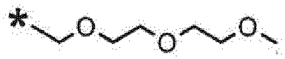 | H |
| A-1-7 | 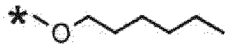 | H |
| A-1-8 | 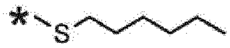 | H |
| A-1-9 | 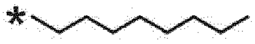 | Cl |
| A-1-10 | $-CO_2H$ | Cl |
| A-1-11 | $-CO_2H$ | Br |
| A-1-12 | 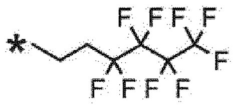 | H |
| A-1-13 | 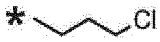 | F |

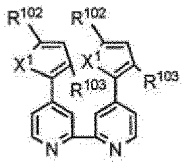

| | $R^{102}$ | $R^{103}$ | $X^1$ |
|---|---|---|---|
| A-2-1 | 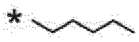 | H | S |
| A-2-2 | 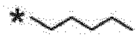 | 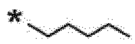 | S |
| A-2-3 | H | 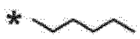 | S |
| A-2-4 | 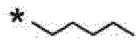 | H | O |
| A-2-5 | 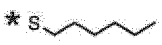 | H | S |
| A-2-6 | 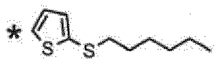 | H | S |
| A-2-7 | 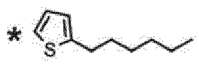 | H | S |
| A-2-8 | 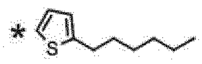 | H | C=C |
| A-2-9 | 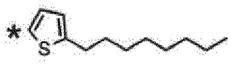 | H | S |
| A-2-10 | 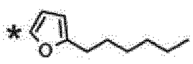 | H | S |
| A-2-11 | 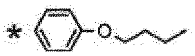 | H | S |

(continued)

| | $R^{102}$ | $R^{103}$ | $X^1$ |
|---|---|---|---|
| A-2-12 | 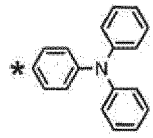 | H | S |
| A-2-13 | 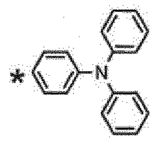 | H | C=C |
| A-2-14 | 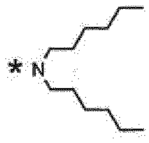 | H | C=C |
| A-2-15 | 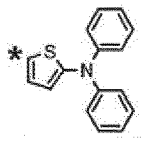 | H | S |
| A-2-16 | 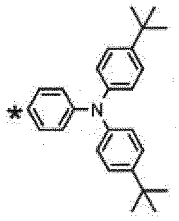 | H | S |

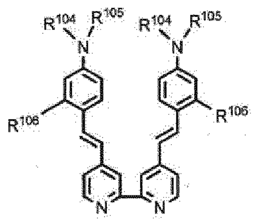

| | $R^{104}$ | $R^{105}$ | $R^{106}$ |
|---|---|---|---|
| A-3-1 | Et | Et | H |
| A-3-2 | Et | Et | *OEt |
| A-3-3 | 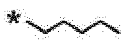 | 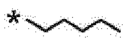 | H |
| A-3-4 | 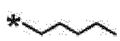 | 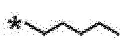 | 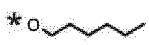 |
| A-3-5 | 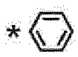 | 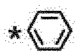 | H |
| A-3-6 | 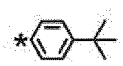 | 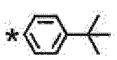 | H |
| A-3-7 | 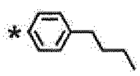 | 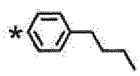 | H |
| A-3-8 | 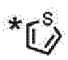 | 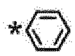 | H |

(continued)

| | $R^{104}$ | $R^{105}$ | $R^{106}$ |
|---|---|---|---|
| A-3-9 | 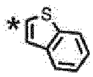 | 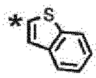 | H |
| A-3-10 | 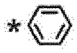 | 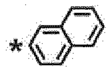 | H |
| A-3-11 | 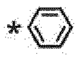 | 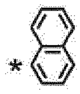 | H |
| A-3-12 | 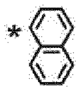 | 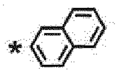 | H |
| A-3-13 | 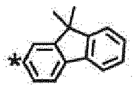 | 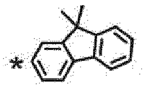 | H |
| A-3-14 | Et | Et | *$N(Et)_2$ |
| A-3-15 | 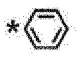 | 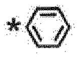 | * $N(Ph)_2$ |

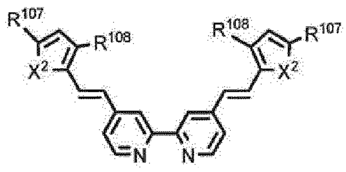

| | $R^{107}$ | $R^{108}$ | $X^2$ |
|---|---|---|---|
| A-4-1 | 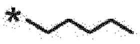 | H | S |
| A-4-2 | 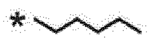 | 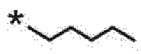 | S |
| A-4-3 | H | 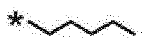 | S |
| A-4-4 | 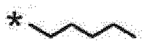 | H | O |
| A-4-5 | 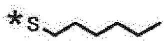 | H | S |
| A-4-6 | 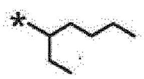 | H | S |
| A-4-7 | 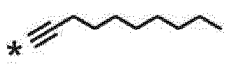 | H | S |
| A-4-8 | 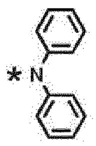 | H | S |

(continued)

| | $R^{107}$ | $R^{108}$ | $X^2$ |
|---|---|---|---|
| A-4-9 | 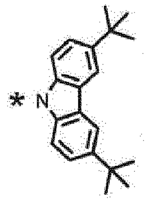 | H | C=C |
| A-4-10 | 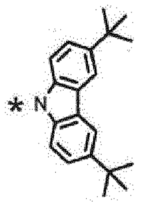 | H | S |
| A-4-11 | 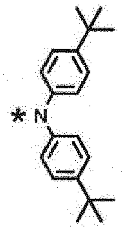 | H | S |

Next, specific examples of the acceptor ligand are shown below.

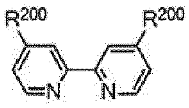

| | $R^{200}$ |
|---|---|
| B-1-1 | $-CO_2H$ |
| B-1-2 | $-SO_3H$ |
| B-1-3 | $-PO_3H_2$ |
| B-1-4 | $-OPO_3H_2$ |
| B-1-5 | -OH |
| B-1-6 | $-NHSO_2CH_3$ |

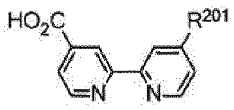

| | $R^{201}$ |
|---|---|
| B-2-1 | $-SO_3H$ |
| B-2-2 | $-PO_3H_2$ |
| B-2-3 | $-OPO_3H_2$ |
| B-2-4 | -OH |
| B-2-5 | $-NHSO_2CH_3$ |

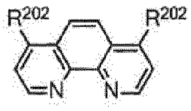

| | $R^{202}$ |
|---|---|
| B-3-1 | $-CO_2H$ |
| B-3-2 | $-SO_3H$ |
| B-3-3 | $-PO_3H_2$ |
| B-3-4 | $-OPO_3H_2$ |
| B-3-5 | -OH |
| B-3-6 | $-NHSO_2CH_3$ |

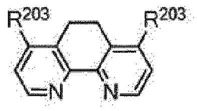

| | $R^{203}$ |
|---|---|
| B-4-1 | $-CO_2H$ |
| B-4-2 | $-SO_3H$ |
| B-4-3 | $-PO_3H_2$ |
| B-4-4 | $-OPO_3H_2$ |
| B-4-5 | -OH |
| B-4-6 | $-NHSO_2CH_3$ |

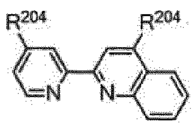

| | $R^{204}$ |
|---|---|
| B-5-1 | $-CO_2H$ |
| B-5-2 | $-SO_3H$ |
| B-5-3 | $-PO_3H_2$ |
| B-5-4 | $-OPO_3H_2$ |
| B-5-5 | -OH |
| B-5-6 | $-NHSO_2CH_3$ |

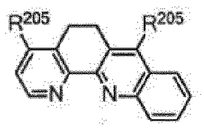

| | $R^{205}$ |
|---|---|
| B-6-1 | $-CO_2H$ |
| B-6-2 | $-SO_3H$ |
| B-6-3 | $-PO_3H_2$ |

(continued)

| | $R^{205}$ |
|---|---|
| B-6-4 | $-OPO_3H_2$ |
| B-6-5 | -OH |
| B-6-6 | $-NHSO_2CH_3$ |

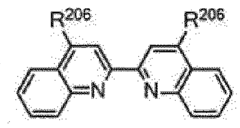

| | $R^{206}$ |
|---|---|
| B-7-1 | $-CO_2H$ |
| B-7-2 | $-SO_3H$ |
| B-7-3 | $-PO_3H_2$ |
| B-7-4 | $-OPO_3H_2$ |
| B-7-5 | -OH |
| B-7-6 | $-NHSO_2CH_3$ |

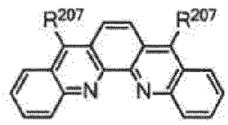

| | $R^{207}$ |
|---|---|
| B-B-1 | $-CO_2H$ |
| B-6-2 | $-SO_3H$ |
| B-8-3 | $-PO_3H_2$ |
| B-3-4 | $-OPO_3H_2$ |
| B-8-5 | -OH |
| B-8-6 | $-NHSO_2CH_3$ |

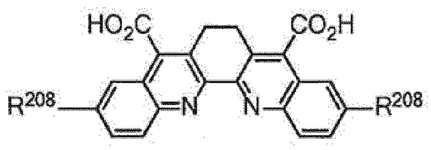

| | $R^{208}$ |
|---|---|
| B-9-1 | -Cl |
| B-9-2 | $-C_5H_{11}$ |
| B-9-3 | -CN |
| B-9-4 | -OH |
| B-9-5 | -H |
| B-9-6 | $-CH_2CO_2H$ |

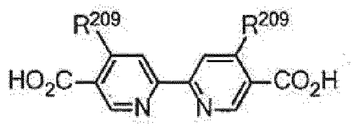

| | $R^{209}$ |
|---|---|
| B-10-1 | -Ph |
| B-10-2 | $-C_5H_{11}$ |
| B-10-3 | -CN |
| B-10-4 | -OH |
| B-10-5 | -H |
| B-10-6 | -Br |

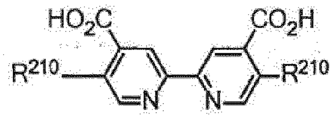

| | $R^{210}$ |
|---|---|
| B-11-1 | -Cl |
| B-11-2 | -Br |
| B-11-3 | $-C_5H_{11}$ |
| B-11-4 | -CN |
| B-11-5 | -OH |
| B-11-6 | -H |
| B-11-7 | $-CH_2CO_2H$ |
| B-11-8 | -Ph |
| B-11-9 | $-CH_2CH_2C_6F_{13}$ |

The dye solution for a photoelectric conversion element contains one kind or two or more kinds of the metal complex dyes.
In a case where the dye solution contains two or more kinds of the metal complex dyes, the two or more kinds of metal complex dyes may be either metal complex dyes represented by different chemical formulae or isomers of metal complex dyes represented by the same chemical formula.
Furthermore, dyes other than the metal complex dyes may also be used in combination. Examples of the dye that can be used in combination include a Ru complex dye, a squarylium cyanine dye, an organic dye, a porphyrin dye, and a phthalocyanine dye, each of which is other than the metal complex dye represented by Formula (1). Among those, the Ru complex dye, the squarylium cyanine dye, or the organic dye is preferable.
In a case where the metal complex dye represented by Formula (1) is used in combination with another dye, the ratio of the mass of the metal complex dye represented by Formula (1)/the mass of another dye is preferably 95/5 to 10/90, more preferably 95/5 to 50/50, still more preferably 95/5 to 60/40, particularly preferably 95/5 to 65/35, and most preferably 95/5 to 70/30.
The content of the metal complex dye in the dye solution for a photoelectric conversion element is not particularly limited, and is preferably 0.01 to 5 mmoles/L, more preferably 0.05 to 2 mmoles/L, and still more preferably 0.1 to 0.5 mmoles/L.

<Solvent>

The solvent used in the present invention includes an alcohol solvent.
The alcohol solvent used in the present invention is a solvent selected from a primary alcohol having 4 or more

carbon atoms in total, which has at least one branched chain, a secondary alcohol having 4 or more carbon atoms in total, which may have a branched chain, and a tertiary alcohol having 5 or more carbon atoms in total, which may have a branched chain, and has a molecular weight of 70 to 300.

The number of hydroxyl groups contained in the alcohol solvent used in the present invention is not particularly limited as long as it is at least one, and is preferably 1 to 4, more preferably 1 to 3, and still more preferably 1 or 2.

In the present invention, in a case where the alcohol solvent has two or more hydroxyl groups, alcohol solvents having higher grades of hydroxyl groups among the grades of the respective hydroxyl groups are employed. For example, a diol having a primary hydroxyl group and a secondary hydroxyl group (for example, 1,2-butanediol) is classified into a secondary alcohol.

The alcohol solvent may be a saturated aliphatic alcohol or an unsaturated aliphatic alcohol, and is preferably a saturated aliphatic alcohol.

The total number of carbon atoms of the primary alcohol is preferably 4 to 20, more preferably 4 to 12, still more preferably 4 to 8, and particularly preferably 4 or 5.

The number of branched chains contained in a molecule of the primary alcohol is not particularly limited as long as it is 1 or more, and is preferably 1 to 5, more preferably 1 to 3, and particularly preferably 1 or 2. Further, the position (carbon atom) at which the branched chain in the molecular structure of the primary alcohol is bonded is not particularly limited, and is preferably the 2- to 8-position, more preferably the 2- to 6-position, and still more preferably the 2- to 4-position, with respect to the carbon atom (1-position) to which the hydroxyl group is bonded. In a case where the primary alcohol has a plurality of branched chains, it is preferable that all the branched chains are at the position.

In the present invention, the branched chain refers to a chain bonded to a linear carbon chain that is the longest chain in the molecular structure of the alcohol.

This "linear carbon chain that is the longest chain" is determined to be inclusive of a substituent in a case where a primary alcohol has the substituent. In this case, a heteroatom derived from the substituent may be included between the carbon atoms that form the linear carbon chain. That is, the branched chain refers to a chain bonded to the longest linear carbon chain (which may include a heteroatom) as the primary alcohol is seen as a whole molecular structure.

The branched chain is not particularly limited, and is preferably a carbon chain, and more preferably a saturated aliphatic carbon chain (including a methyl group). Also, for this branched chain, in a case where the primary alcohol has a substituent, a heteroatom derived from the substituent may be included in a carbon chain which is the branched chain, in the same manner as "a linear carbon chain which is the longest chain". For example, in a case where the primary alcohol has an alkoxy group as the substituent, an oxygen atom of an alkoxy group may be included in "a linear carbon chain which is the longest chain" of the primary alcohol. Further, in a case where the primary alcohol has a substituent, a branched chain may be contained in the molecular structure of the primary alcohol (other than the substituent) or in the molecular structure of the substituent.

For example, (2-isopropoxyethoxy)ethanol which will be described later has an ethoxy group and a 2-isopropoxy group as the substituent. In this alcohol, a 3,6-dioxaoctane chain ($CH_3$-$CH_2$-O-$CH_2$-$CH_2$-O-$CH_2$-$CH_3$ chain) including the two substituents can serve as "the linear carbon chain which is the longest chain". A methyl group contained in the 2-isopropoxy group which is a substituent can serve as the branched chain.

The heteroatom which may be included in the linear carbon chain and the branched chain are not particularly limited, and examples thereof include heteroatoms derived from the groups included in the substituent group T which will be described later. Such a heteroatom is preferably a nitrogen atom, an oxygen atom, a sulfur atom, a silicon atom, a selenium atom, or a phosphorus atom, more preferably a nitrogen atom, an oxygen atom, or a sulfur atom, and still more preferably an oxygen atom.

The total number of carbon atoms of the secondary alcohol is preferably 4 to 18, more preferably 4 to 12, and still more preferably 4 to 8.

With regard to the secondary alcohol, in a case where the carbon atom to which a hydroxyl group is bonded is secondary, the molecular structure of the secondary alcohol is not particularly limited, and may have a branched chain (branched alcohol) or may not have a branched chain (linear alcohol), and may have a cyclic structure (cyclic alcohol).

The total number of carbon atoms of the tertiary alcohol is 5 to 18, more preferably 5 to 12, and still more preferably 5 to 8.

With regard to the tertiary alcohol, in a case where a carbon atom to which a hydroxyl group is bonded is tertiary, a molecular structure of the tertiary alcohol is not particularly limited, and may or may not have a branched chain, and may have a cyclic structure.

The primary to tertiary alcohols may have a substituent within a scope not impairing the effects of the present invention. The substituent is not particularly limited as long as it is other than a hydroxyl group, and examples thereof include groups selected from the substituent group T, and specifically an alkoxy group. Incidentally, as the substituent, a group other than an aliphatic hydrocarbon group (an alkyl group, or an alkenyl or alkynyl group) is preferable.

The number of the substituents which may be contained in the primary to tertiary alcohols is not particularly limited, may be 1 or more, and is preferably 1 to 4, and more preferably 1 or 2. In a case where a plurality of substituents

are present, these substituents may be the same as or different from each other, and they may be present respectively or may be present in a state of being bonded together as in a 2-isopropoxyethoxy group.

The number of carbon atoms of the alkoxy group which may be contained in the primary to tertiary alcohols as a substituent is preferably 1 to 8, and particularly preferably 1 to 4, among the ranges which will be described later.

In the present invention, in a case where the alcohol has a substituent, the number of carbon atoms contained in the substituents are also countered for the total number of carbon atoms of the primary to tertiary alcohols.

The molecular weight of the alcohol solvent is preferably 70 to 180, more preferably 70 to 150, still more preferably 70 to 120, and particularly preferably 70 to 90.

The alcohol solvent is preferably the primary alcohol or the secondary alcohol, and more preferably the primary alcohol. However, in a case where the alcohol solvent has an alkoxy group as the substituent, a preferred alcohol is the primary alcohol or the secondary alcohol.

It is preferable that the alcohol solvent does not have an acidic group. In the present invention, "the alcohol solvent not having an acidic group" refers to a solvent that can be used as a solvent for the metal complex dye among the alcohol compounds not having an acidic group (for example, a sulfo group, or a carboxyl group or a salt thereof).

Specific examples of the alcohol solvent used in the present invention are described below, but the present invention is not limited to these alcohol solvents. In the primary alcohols shown below, the position at which a branched chain is bonded to a linear carbon chain which is the longest chain is denoted as a "branching position".

| Name | Structure | Molecular weight | Grade | Total number of carbon of atoms | Branching position |
|---|---|---|---|---|---|
| Isobutanol | 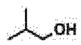 | 74.1 | 1 | 4 | 2 |
| 2,2-Dimethyt-1-propanol | 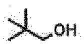 | 88.2 | 1 | 5 | 2 |
| 2-Methyl-1-butanol | 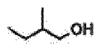 | 88.2 | 1 | 5 | 2 |
| 3-Methyl-1-butanol | 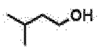 | 88.2 | 1 | 5 | 3 |
| 2-Methyl-1-pentanol | 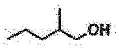 | 102.2 | 1 | 6 | 2 |
| 3-Methyl-1-pentanol | 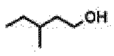 | 102.2 | 1 | 6 | 3 |
| 4-Methyl-1-pentanol | 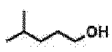 | 102.2 | 1 | 6 | 4 |
| 2-Ethyl-1-butanol | 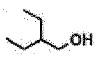 | 102.2 | 1 | 6 | 2 |
| 2-Ethyl-1-hexanol | 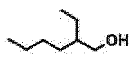 | 130.2 | 1 | 8 | 2 |
| 2-Butyl-1-octanol | 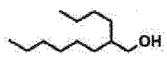 | 186.3 | 1 | 12 | 2 |
| 2-Hexyl-1-decanol | 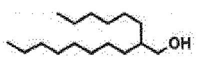 | 242.4 | 1 | 16 | 2 |
| 2-Octyl-1-dodecanol | 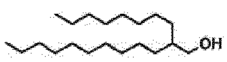 | 298.6 | 1 | 20 | 2 |
| 3,7-Dimethyl-1-octanol | 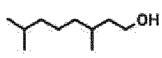 | 158.3 | 1 | 10 | 3,7 |
| 3-Methoxy-1-butanol | 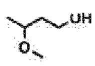 | 104.2 | 1 | 5 | 3 |
| 3-Methoxy-3-Methyl-1-butanol | 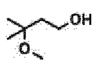 | 118.2 | 1 | 6 | 3,3 |

(continued)

| Name | Structure | Molecular weight | Grade | Total number of carbon of atoms | Branching position |
|---|---|---|---|---|---|
| 2-Methyl-1,3-propanediol | 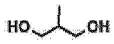 | 90.1 | 1 | 4 | 2 |
| 2-Methoxy-1-butanol | 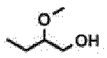 | 104.2 | 1 | 5 | 2 |
| 2-Isopropoxyethanol | 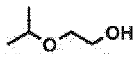 | 104.2 | 1 | 5 | 4 |
| 2-Isobutoxyethanol | 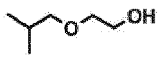 | 118.2 | 1 | 6 | 5 |
| 2-tert-Butoxyethanol | 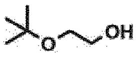 | 118.2 | 1 | 6 | 4,4 |
| 2-(2-Ethylhexyloxy) ethanol | 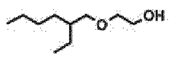 | 174.3 | 1 | 10 | 5 |
| (2-Isopropoxyethoxy) ethanol | 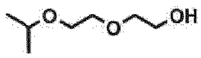 | 148.2 | 1 | 7 | 7 |
| (2-Isobutoxyethoxy) ethanol | 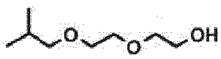 | 162.2 | 1 | 8 | 8 |
| (2-(2-Ethylhexyloxy) ethoxy)ethanol | 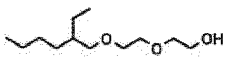 | 218.3 | 1 | 12 | 8 |

| Name | Structure | Molecular weight | Grade | Total number of carbon atoms |
|---|---|---|---|---|
| 2-Butanol | 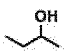 | 74.1 | 2 | 4 |
| 2-Pentanol | 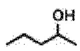 | 88.2 | 2 | 5 |
| 3-Pentanol | 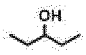 | 88.2 | 2 | 5 |
| 3-Methyl-2-butanol | 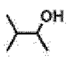 | 88.2 | 2 | 5 |
| 2-Hexanol | 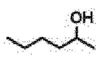 | 102.2 | 2 | 6 |
| 4-Methyl-2-pentanol | 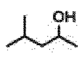 | 102.2 | 2 | 6 |
| Cyclohexanol | 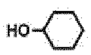 | 102.2 | 2 | 6 |
| 2-Octanol | 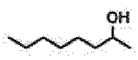 | 130.2 | 2 | 8 |
| 2-Tetradecanol | 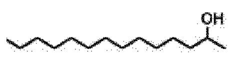 | 214.4 | 2 | 14 |
| 1,2-Butanediol | 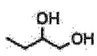 | 90.1 | 2 | 4 |
| 1-Methoxy-2-propanol | 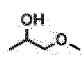 | 90.1 | 2 | 4 |

(continued)

| Name | Structure | Molecular weight | Grade | Total number of carbon atoms |
|---|---|---|---|---|
| 1-Methoxy-2-butanol | 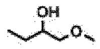 | 104.2 | 2 | 5 |
| 1-Ethoxy-2-propanol | 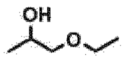 | 104.2 | 2 | 5 |
| 1-Propoxy-2-propanol | 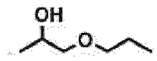 | 118.2 | 2 | 6 |
| 1-Butoxy-2-propanol | 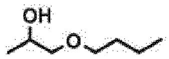 | 132.2 | 2 | 7 |
| 1-(1-Methoxy-2-propoxy)-2-propanol | 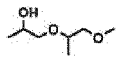 | 148.2 | 2 | 7 |
| 1-(1-Propoxy-2-propoxy)-2-propanol | 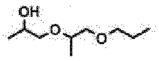 | 176.3 | 2 | 9 |
| 1-(1-Butoxy-2-propoxy)-2-propanol | 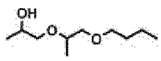 | 190.3 | 2 | 10 |
| t-Amylalcohol | 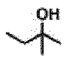 | 88.2 | 3 | 5 |
| 2-Methyl-2-pentanol | 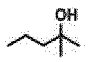 | 102.2 | 3 | 6 |
| 3-Methyl-1,3-butanediol | 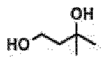 | 104.2 | 3 | 5 |

Among those, the alcohol solvent is preferably at least one selected from isobutanol, 2,2-dimethyl-1-propanol, 2-methyl-1-butanol, 3-methyl-1-butanol, 4-methyl-1-pentanol, 2-butyl-1-octanol, 2-octyl-1-dodecanol, 3-methoxy-3-methyl-1-butanol, 2-methyl-1,3-propanediol, 2-butanol, 2-hexanol, 4-methyl-2-pentanol, cyclohexanol, 1-methoxy-2-propanol, t-amylalcohol (2-methyl-2-butanol), 2-methyl-2-pentanol, and 3-methyl-1,3-butanediol, more preferably at least one selected from isobutanol, 2-methyl-1-butanol, 3-methyl-1-butanol, 2,2-dimethyl-1-propanol, and 1-methoxy-2-propanol, and still more preferably at least one selected from isobutanol, 2-methyl-1-butanol, 3-methyl-1-butanol, and 2,2-dimethyl-1-propanol.

The solvent (dye solution for a photoelectric conversion element) contains one kind or two or more kinds of the alcohol solvents.

In the present invention, a solvent other than the alcohol solvent can also be used in combination.

Examples of such solvents include the solvents described in JP2001-291534A, but are not particularly limited thereto. In the present invention, an organic solvent is preferable, and at least one selected from a ketone solvent, an amide solvent, a nitrile solvent, and a hydrocarbon solvent is more preferable. As the solvent other than the alcohol solvent, a ketone solvent, an amide solvent, or a nitrile solvent is preferable, an amide solvent or a nitrile solvent is more preferable, and a nitrile solvent is still more preferable.

Examples of the ketone solvent include acetone, 2-butanone, 2-pentanone, and 3-methyl-2-butanone. Examples of the amide solvent include dimethylformamide and dimethylacetamide. Examples of the nitrile solvent include acetonitrile.

The volume content ratio of the alcohol solvent in the solvent is not particularly limited, in a view of photoelectric conversion efficiency, the volume content ratio is preferably 50% or more, and more preferably 75% or more, and still more preferably, only an alcohol solvent is included (the volume content ratio of the alcohol solvent is 100%). Here, the expression, the alcohol solvent alone being included, means that a solvent inevitably present in the alcohol solvent is not excluded and the solvent may be contained to such an extent that the effects of the present invention are not impaired. For example, as long as the content of the solvents other than the alcohol solvents is 5% by volume or less, any of the solvents may be included.

The content ratio of the solvent in the dye solution for a photoelectric conversion element is not particularly

limited, and is preferably 25% by mass or more, more preferably 50% by mass or more, and still more preferably 75% by mass or more.

A combination of the metal complex dye and the solvent in the dye solution of the present invention is not particularly limited, and the metal complex dye and the solvent can be appropriately combined. For example, specific examples of the preferred combinations of the metal complex dye and the alcohol solvent are shown in Table 1 and Examples below, but the present invention is not limited to these combinations.

[Table 1-1]

| Combination No. | Metal complex dye | | | | | Alcohol solvent |
|---|---|---|---|---|---|---|
| | No. | Dye structure | | | | |
| | | Auxiliary ligand No. | Acceptor ligand No. | $L^1$ | $L^2$ | |
| K1 | 1 | A-1-1 | B-1-1 | NCS | NCS | Isobutanol |
| K2 | 2 | A-1-3 | B-1-1 | NCS | NCS | Isobutanol |
| K3 | 3 | A-1-5 | B-1-1 | NCS | NCS | Isobutanol |
| K4 | 4 | A-2-1 | B-1-1 | NCS | NCS | Isobutanol |
| K5 | 5 | A-2-1 | B-1-1 | NCS | NCS | 2-Butanol |
| K6 | 6 | A-2-5 | B-1-1 | NCS | NCS | Isobutanol |
| K7 | 7 | A-2-6 | B-1-1 | NCS | NCS | Isobutanol |
| K8 | 8 | A-2-6 | B-1-1 | NCS | NCS | 4-Methyl-1-pentanol |
| K9 | 9 | A-2-6 | B-1-1 | NCS | NCS | 2-Octyl-1-dodecanol |
| K10 | 10 | A-2-9 | B-1-1 | NCS | NCS | Isobutanol |
| K11 | 11 | A-2-12 | B-1-1 | NCS | NCS | Isobutanol |
| K12 | 12 | A-2-16 | B-1-1 | NCS | NCS | Isobutanol |
| K13 | 13 | A-3-1 | B-1-1 | NCS | NCS | Isobutanol |
| K14 | 14 | A-3-3 | B-1-1 | NCS | NCS | Isobutanol |
| K15 | 15 | A-3-4 | B-1-1 | NCS | NCS | Isobutanol |
| K16 | 16 | A-3-4 | B-1-1 | NCS | NCS | 2-Methyl-1,3-propanediol |
| K17 | 17 | A-3-5 | B-1-1 | NCS | NCS | Isobutanol |
| K18 | 18 | A-3-5 | B-1-1 | NCS | NCS | 2-Hexanol |
| K19 | 19 | A-3-5 | B-1-1 | NCS | NCS | t-Amylalcohol |
| K20 | 20 | A-3-5 | B-1-1 | NCS | NCS | 2-Methyl-2-pentanol |

[Table 1-2]

| Combination No. | Metal complex dye | | | | | Alcohol solvent |
|---|---|---|---|---|---|---|
| | No. | Dye structure | | | | |
| | | Auxiliary ligand No. | Acceptor ligand No. | $L^1$ | $L^2$ | |
| K21 | 21 | A-3-6 | B-1-1 | NCS | NCS | Isobutanol |
| K22 | 22 | A-3-6 | B-1-1 | NCS | NCS | 2,2-Dimethyl-1-propanol |
| K23 | 23 | A-3-6 | B-1-1 | NCS | NCS | 2-Methyl-1-butanol |
| K24 | 24 | A-3-6 | B-1-1 | NCS | NCS | 3-Methyl-1-butanol |
| K25 | 25 | A-3-6 | B-1-1 | NCS | NCS | 2-Butyl-1-octanol |
| K26 | 26 | A-3-6 | B-1-1 | NCS | NCS | 2-Octyl-1-dodecanol |

(continued)

| Combination No. | Metal complex dye | | | | | Alcohol solvent |
|---|---|---|---|---|---|---|
| | No. | Dye structure | | | | |
| | | Auxiliary ligand No. | Acceptor ligand No. | $L^1$ | $L^2$ | |
| K27 | 27 | A-3-6 | B-1-1 | NCS | NCS | 3-Methoxy-3-methyl-1-butanol |
| K28 | 28 | A-3-6 | B-1-1 | NCS | NCS | 2-Butanol |
| K29 | 29 | A-3-6 | B-1-1 | NCS | NCS | 4-Methyl-2-pentanol |
| K30 | 30 | A-3-6 | B-1-1 | NCS | NCS | Cyclohexanol |
| K31 | 31 | A-3-6 | B-1-1 | NCS | NCS | 1-Methoxy-2-propanol |
| K32 | 32 | A-3-6 | B-1-1 | NCS | NCS | t-Amylalcohol |
| K33 | 33 | A-3-6 | B-1-1 | NCS | NCS | 3-Methyl-1,3-butanediol |
| K34 | 34 | A-3-6 | B-1-2 | NCS | NCS | t-Amylalcohol |
| K35 | 35 | A-3-6 | B-5-1 | NCS | NCS | Isobutanol |
| K36 | 36 | A-3-6 | B-7-1 | NCS | NCS | Isobutanol |
| K37 | 37 | A-3-6 | B-11-1 | NCS | NCS | Isobutanol |
| K38 | 38 | A-3-9 | B-1-1 | NCS | NCS | Isobutanol |
| K39 | 39 | A-3-9 | B-1-1 | NCS | NCS | 2-Ethyl-1-butanol |
| K40 | 40 | A-3-9 | B-1-1 | NCS | NCS | 3,7-Dimethyl-1-octanol |
| K41 | 41 | A-3-9 | B-1-1 | NCS | NCS | 2-Octanol |
| K42 | 42 | A-3-9 | B-1-1 | NCS | NCS | 2-Octyl-1-dodecanol |
| K43 | 43 | A-3-9 | B-3-1 | NCS | NCS | Isobutanol |
| K44 | 44 | A-4-1 | B-1-1 | NCS | NCS | Isobutanol |
| K45 | 45 | A-4-1 | B-1-1 | NCS | NCS | 3-Methyl-1-butanol |
| K46 | 46 | A-4-1 | B-1-1 | NCS | NCS | Cyclohexanol |
| K47 | 47 | A-4-1 | B-1-1 | NCS | NCS | t-Amylalcohol |
| K48 | 48 | A-4-7 | B-1-1 | NCS | NCS | Isobutanol |
| K49 | 49 | A-4-7 | B-1-2 | NCS | NCS | Isobutanol |
| K50 | 50 | A-4-8 | B-1-1 | NCS | NCS | Isobutanol |
| K51 | 51 | A-4-11 | B-1-1 | NCS | NCS | Isobutanol |

[Table 1-3]

| Combination No. | Metal complex dye | | | | | Alcohol solvent |
|---|---|---|---|---|---|---|
| | No. | Dye structure | | | | |
| | | Auxiliary ligand No. | Acceptor ligand No. | $L^1$ | $L^2$ | |
| K52 | 52 | A-3-6 | B-1-1 | NCS | NCS | 3-Methoxy-1-butanol |
| K53 | 53 | A-3-6 | B-1-1 | NCS | NCS | 2-Methoxy-1-butanol |
| K54 | 54 | A-3-6 | B-1-1 | NCS | NCS | 2-Isopropoxyethanol |
| K55 | 55 | A-3-6 | B-1-1 | NCS | NCS | 2-Isobutoxyethanol |
| K56 | 56 | A-3-6 | B-1-1 | NCS | NCS | 2-tert-Butoxyethanol |

(continued)

| Combination No. | Metal complex dye | | | | | Alcohol solvent |
|---|---|---|---|---|---|---|
| | No. | Dye structure | | | | |
| | | Auxiliary ligand No. | Acceptor ligand No. | $L^1$ | $L^2$ | |
| K57 | 57 | A-3-6 | B-1-1 | NCS | NCS | 2-(2-Ethylhexyloxy)ethanol |
| K58 | 58 | A-3-6 | B-1-1 | NCS | NCS | (2-Isopropoxyethoxy)ethanol |
| K59 | 59 | A-3-6 | B-1-1 | NCS | NCS | (2-Isobutoxyethoxy)ethanol |
| K60 | 60 | A-3-6 | B-1-1 | NCS | NCS | (2-(2-Ethylhexyloxy)ethoxy) ethanol |
| K61 | 61 | A-3-6 | B-1-1 | NCS | NCS | 1-Methoxy-2-propanol |
| K62 | 62 | A-3-6 | B-1-1 | NCS | NCS | 1-Ethoxy-2-propanol |
| K63 | 63 | A-3-6 | B-1-1 | NCS | NCS | 1-Propoxy-2-propanol |
| K64 | 64 | A-3-6 | B-1-1 | NCS | NCS | 1-Butoxy-2-propanol |
| K65 | 65 | A-3-6 | B-1-1 | NCS | NCS | 1-(1-Methoxy-2-propoxy)-2-propanol |
| K66 | 66 | A-3-6 | B-1-1 | NCS | NCS | 1-(1-Propoxy-2-propoxy)-2-propanol |
| K67 | 67 | A-3-6 | B-1-1 | NCS | NCS | 1-(1-Butoxy-2-propoxy)-2-propanol |

<Additives>

The dye solution of the present invention may contain various additives, in addition to the components.

As such an additive, additives that are usually used in the dye solution can be used without particular limitation, and examples thereof include a co-adsorbent.

- Co-Adsorbent -

The dye solution of the present invention preferably contains a co-adsorbent.

Such a co-adsorbent is preferably a co-adsorbent having at least one acidic group (preferably a carboxyl group or a salt thereof), and examples thereof include a fatty acid and a compound having a steroid skeleton.

The fatty acid may be a saturated fatty acid or an unsaturated fatty acid, and examples thereof include butanoic acid, hexanoic acid, octanoic acid, decanoic acid, hexadecanoic acid, dodecanoic acid, palmitic acid, stearic acid, oleic acid, linoleic acid, and linolenic acid.

Examples of the compound having a steroid skeleton include cholic acid, glycocholic acid, chenodeoxycholic acid, hyocholic acid, deoxycholic acid, lithocholic acid, and ursodeoxycholic acid, and the compound is preferably cholic acid, deoxycholic acid, or chenodeoxycholic acid, and more preferably chenodeoxycholic acid.

Preferred examples of the co-adsorbent include the compound represented by Formula (CA) described in paragraph Nos. 0125 to 0129 of JP2014-82187A, and the description of paragraph Nos. 0125 to 0129 of JP2014-82187A are preferably incorporated herein by reference.

By adsorbing the co-adsorbent onto semiconductor fine particles 22, the co-adsorbent exhibits an effect of suppressing inefficient association of the metal complex dye and an effect of preventing reverse electron transfer from surfaces of semiconductor fine particles to a redox system in an electrolyte.

The content of the co-adsorbent in the dye solution for a photoelectric conversion element is not particularly limited, and in a view of exhibiting the above actions effectively, the content is preferably 1 to 200 moles, more preferably 5 to 150 moles, and still more preferably 10 to 100 moles, with respect to 1 mole of the metal complex dye.

In a view of dye adsorption, it is preferable that the dye solution of the present invention has a small moisture content ratio. For example, the moisture content ratio is preferably 0% to 1% by mass, at least during a use. The moisture content ratio can be adjusted by a common method, at least during a use.

<Preparation Method>

A method for preparing the dye solution for a photoelectric conversion element is not particularly limited, and a common preparation method can be employed. For example, by adding a metal complex dye and the like to the solvent for dissolution, the dye solution for a photoelectric conversion element of the present invention can be prepared.

In order to accelerate dissolution of the metal complex dye and the like, as desired, a stirring treatment, a shaking treatment, an ultrasonic wave irradiation treatment, or the like can be applied. Further, solids (dispersions, insolubles, or the like) can be removed by a common solid-liquid separation method such as filtration, at least during a use.

[Kit for Preparing Dye Solution]

The dye solution for a photoelectric conversion element of the present invention is used as a composition containing a metal complex dye and a solvent as described above. Further, it is one of preferred aspects that the dye solution for a photoelectric conversion element is used for a kit for preparing a dye solution, in which the components are divided into into a plurality.

Examples of such a kit include a kit having a combination of a dye agent (first agent) containing at least one of the above-mentioned metal complex dyes, and a liquid agent (second agent) containing the above-mentioned solvent. This kit can be used for dye adsorption by preparing a dye solution for a photoelectric conversion element in the same method as the above-mentioned method for preparing a dye solution for a photoelectric conversion element. Preferably, a dye agent and a liquid agent are mixed to reach a predetermined dye content, a metal complex dye is dissolved in a solvent, and solids are removed by a common solid-liquid separation method, as desired, to prepare a dye solution for a photoelectric conversion element. By the use of the kit, the metal complex dye can be prevented from being decomposed and the dye solution can be prevented from absorbing moisture, whereby a photoconductor layer or a dye-sensitized solar cell, each exhibiting high performance, can be produced.

In the kit, in a case where a plurality of kinds of metal complex dyes are used, a dye agent having these dyes may be used or a plurality of dye agents each having one of the dyes may be used.

The dye agent and the liquid agent may each contain the above-mentioned additive, and may also have a third agent containing an additive, in addition to the dye agent and the liquid agent.

The dye agent, the liquid agent, and the third agent may contain each of predetermined components in arbitrary contents.

The kit for preparing a dye solution of the present invention may include a mixing container or the like, in addition to the above-mentioned respective agents.

[Photoelectric Conversion Element and Dye-Sensitized Solar Cell]

Next, the photoelectric conversion element and the dye-sensitized solar cell produced by the method for producing a photoelectric conversion element of the present invention (hereinafter referred to as the production method of the present invention in some cases) will be described.

The photoelectric conversion element produced by the production method of the present invention has an electrically conductive support and semiconductor fine particles having a dye carried thereon, and has a photoconductor layer including an electrolyte between the semiconductor fine particles, a charge transfer layer including an electrolyte, and a counter electrode (opposite electrode) in this order.

In the photoelectric conversion element and the dye-sensitized solar cell of the present invention, the above-mentioned alcohol solvent used for the dye adsorption remains in the photoconductor layer (semiconductor fine particles). Accordingly, by detecting the remaining alcohol solvent, it can be confirmed that the dye solution for a photoelectric conversion element of the present invention was used for the production of a photoelectric conversion element or a solar cell. The method for detecting the alcohol solvent will be described later in Examples.

The photoelectric conversion element produced by the production method of the present invention is not particularly limited in terms of configurations other than the configuration defined in the present invention, and may employ known configurations regarding photoelectric conversion elements. The respective layers constituting the photoelectric conversion element of the present invention are designed depending on purposes, and may be formed into, for example, a single layer or multiple layers. Further, layers other than the layers may be included, as desired.

The dye-sensitized solar cell produced by the production method of the present invention is formed by using the photoelectric conversion element of the present invention.

Hereinafter, preferred embodiments of the photoelectric conversion element and the dye-sensitized solar cell of the present invention will be described.

A system 100 shown in Fig. 1 is a system in which a photoelectric conversion element 10 in the first aspect, which is produced by the production method of the present invention, is applied in cell uses where an operating means

M (for example, an electric motor) in an external circuit 6 is forced to work.

The photoelectric conversion element 10 includes semiconductor fine particles 22 sensitized by carrying an electrically conductive support 1 and a dye (metal complex dye) 21, a photoconductor layer 2 including an electrolyte between the semiconductor fine particles 22, a charge transfer layer 3 that is a hole transport layer, and a counter electrode 4.

In the photoelectric conversion element 10, the photoconductor layer 2 is also referred to as an oxide semiconductor electrode. Further, the light-receiving electrode 5 has the electrically conductive support 1 and the photoconductor layer 2, and functions as a functional electrode.

In the system 100 in which the photoelectric conversion element 10 is applied, light incident to the photoconductor layer 2 excites the metal complex dye 21. The excited metal complex dye 21 has electrons having high energy, and these electrons are transferred from the metal complex dye 21 to a conduction band of the semiconductor fine particles 22, and further reach the electrically conductive support 1 by diffusion. At this time, the metal complex dye 21 is in an oxidized form (cation). While the electrons reaching the electrically conductive support 1 work in an external circuit 6, they reach the oxidized form of the metal complex dye 21 through the counter electrode 4 and the charge transfer layer 3, and reduce the oxidized form, whereby the system 100 functions as a solar cell.

A dye-sensitized solar cell 20 shown in Fig. 2 is constituted with a photoelectric conversion element, in the second aspect, which is produced by the production method of the present invention.

With respect to the photoelectric conversion element shown in Fig. 1, the photoelectric conversion element which becomes the dye-sensitized solar cell 20 is different in the configurations of the electrically conductive support 41 and the photoconductor layer 42, and also differs in that it has a spacer S, but except for these, has the same configuration as the photoelectric conversion element 10 shown in Fig. 1. That is, the electrically conductive support 41 has a bilayered structure including a substrate 44 and a transparent electrically-conductive film 43 which is formed on the surface of the substrate 44. Further, the photoconductor layer 42 has a bilayered structure including a semiconductor layer 45 and a light-scattering layer 46 which is formed adjacent to the semiconductor layer 45. This photoconductor layer 42 is also referred to as an oxide semiconductor electrode. A spacer S is provided between the electrically conductive support 41 and the counter electrode 48. In the dye-sensitized solar cell 20, 40 is a light-receiving electrode and 47 is a charge transfer layer.

The dye-sensitized solar cell 20, similar to the system 100 in which the photoelectric conversion element 10 is applied, functions as a solar cell by light incident on the photoconductor layer 42.

The photoelectric conversion element and the dye-sensitized solar cell of the present invention exhibit excellent photoelectric conversion efficiency even in a low-illuminance environment. Accordingly, the photoelectric conversion element and the dye-sensitized solar cell are suitably used even in a low-illuminance environment.

The dye-sensitized solar cell using the photoelectric conversion element of the present invention is also referred to as a dye-sensitized photoelectrochemical cell.

The photoelectric conversion element and the dye-sensitized solar cell of the present invention are not limited to the above preferred aspects, and the configuration of each of the aspects can be combined as appropriate within a range not departing from the scope of the present invention.

In the present invention, the materials and the respective members for use in the photoelectric conversion element or the dye-sensitized solar cell can be prepared by ordinary methods. Reference can be made to, for example, US4927721A, US4684537A, US5084365A, US5350644A, US5463057A, US5525440A, JP1995-249790A (JP-H07-249790A), JP2001-185244A, JP2001-210390A, JP2003-217688A, JP2004-220974A, and JP2008-135197A.

Next, preferred aspects of the main members of the photoelectric conversion element and the dye-sensitized solar cell will be described.

<Electrically Conductive Support>

The electrically conductive support is not particularly limited as long as it has electrical conductivity and is capable of supporting a photoconductor layer 2 or the like. The electrically conductive support is preferably an electrically conductive support 1 formed of a material having electrical conductivity, such as a metal, or an electrically conductive support 41 having a glass or plastic substrate 44 and a transparent electrically-conductive film 43 formed on the surface of the substrate 44.

Among them, the electrically conductive support 41 having the transparent electrically-conductive film 43 of a metal oxide on the surface of the substrate 44 is more preferable. Such the electrically conductive support 41 is obtained by applying an electrically conductive metal oxide onto the surface of the substrate 44 to form a transparent electrically-conductive film 43. Examples of the substrate 44 formed of plastics include the transparent polymer films described in paragraph No. 0153 of JP2001-291534A. Further, as a material which forms the substrate 44, ceramics (JP2005-135902A) or electrically conductive resins (JP2001-160425A) can be used, in addition to glass and plastics. As the metal oxide, tin oxide (TO) is preferable, and indium-tin oxide (tin-doped indium oxide; ITO), and fluorine-doped

tin oxide such as tin oxide which has been doped with fluorine (FTO) are particularly preferable. In this case, the amount of the metal oxide to be applied is preferably 0.1 to 100 g, per square meter of the surface area of the substrate 44. In a case of using the electrically conductive support 41, it is preferable that light is incident from the side of the substrate 44.

It is preferable that the electrically conductive supports 1 and 41 are substantially transparent. The expression, "substantially transparent", means that the transmittance of light (at a wavelength of 300 to 1,200 nm) is 10% or more, preferably 50% or more, and particularly preferably 80% or more.

The thickness of the electrically conductive supports 1 and 41 is not particularly limited, but is preferably 0.05 μm to 10 mm, more preferably 0.1 μm to 5 mm, and particularly preferably 0.3 μm to 4 mm.

In a case of having a transparent electrically-conductive film 43, the thickness of the transparent electrically-conductive film 43 is preferably 0.01 to 30 μm, more preferably 0.03 to 25 μm, and particularly preferably 0.05 to 20 μm.

It is preferable that the electrically conductive supports 1 and 41 have a metal oxide coating film including a metal oxide on the surface thereof. As the metal oxide, the metal oxide that forms the transparent electrically-conductive film 43 or the metal oxide mentioned as the metal oxide as the semiconductor fine particles which will be described later can be used, with the metal oxide mentioned as the semiconductor fine particles being preferable. The metal oxide may be the same as or different from the metal oxide that forms the transparent electrically-conductive film 43 or the metal oxide mentioned as the semi-conductive fine particles. The metal oxide coating film is usually formed on a thin film, and preferably has a thickness of 0.01 to 100 nm, for example. A method for forming the metal oxide coating film is not particularly limited, and examples thereof include the same method as the method for forming a layer formed by the semiconductor fine particles, which will be described later. For example, a liquid including a metal oxide or a precursor thereof (for example, a halide and an alkoxide) can be applied and heated (calcined) to form a metal oxide coating film.

The electrically conductive supports 1 and 41 may be provided with a light management function at the surface, and may have, for example, the anti-reflection film having a high refractive index film and a low refractive index oxide film alternately laminated described in JP2003-123859A, and the light guide function described in JP2002-260746A on the surface.

<Photoconductor Layer>

As long as the photoconductor layer has semiconductor fine particles 22 carrying the dye 21 thereon and an electrolyte, it is not particularly limited in terms of other configurations. Preferred examples thereof include the photoconductor layer 2 and the photoconductor layer 42.

- Semiconductor Fine Particles (Layer Formed by Semiconductor Fine Particles) -

The semiconductor fine particles 22 are preferably fine particles of chalcogenides of metals (for example, oxides, sulfides, and selenides) or of compounds having perovskite type crystal structures. Preferred examples of the chalcogenides of metals include oxides of titanium, tin, zinc, tungsten, zirconium, hafnium, strontium, indium, cerium, yttrium, lanthanum, vanadium, niobium, or tantalum, cadmium sulfide, and cadmium selenide. Preferred examples of the compounds having perovskite type crystal structures include strontium titanate and calcium titanate. Among these, titanium oxide (titania), zinc oxide, tin oxide, and tungsten oxide are particularly preferable.

Examples of the crystal structure of titania include structures of an anatase type, a brookite type, and a rutile type, with the structures of an anatase type and a brookite type being preferable. A titania nanotube, nanowire, or nanorod may be used singly or in mixture with titania fine particles.

The particle diameter of the semiconductor fine particles 22 is expressed in terms of an average particle diameter using a diameter when a projected area is converted into a circle, and is preferably 0.001 to 1 μm as primary particles, and 0.01 to 100 μm as an average particle diameter of dispersions. Examples of the method for coating the semiconductor fine particles 22 on the electrically conductive supports 1 or 41 include a wet method, a dry method, and other methods.

It is preferable that the semiconductor fine particles 22 have a large surface area so that they may adsorb a large amount of the dye 21. For example, in a state where the semiconductor fine particles 22 are coated on the electrically conductive support 1 or 41, the surface area is preferably 10 times or more, and more preferably 100 times or more, with respect to the projected area. The upper limit of this value is not particularly limited, and the upper limit is usually approximately 5,000 times. Generally, as the thickness of the layer formed by semiconductor fine particles (having the same definition as the photoconductor layer) is higher, the amount of the dye 21 that can be carried per unit area increases. As a result, the absorption efficiency of light increases, but a diffusion distance of the generated electrons increases, and thus, a loss due to charge recombination also increases.

Although the thickness of the layer formed by the semiconductor fine particles may vary depending on the utility of the photoelectric conversion element, the thickness is typically preferably 0.1 to 100 μm, more preferably 1 to 50 μm, and still more preferably 3 to 30 μm.

- Light-Scattering Layer -

In the present invention, the light-scattering layer is different from a semiconductor layer 45 formed with the semiconductor fine particles 22 in that it has a function of scattering incidence rays.
In the dye-sensitized solar cell 20, the light-scattering layer 46 preferably contains rod-shaped or plate-shaped metal oxide fine particles. Examples of the metal oxide to be used in the light-scattering layer 46 include the chalcogenides (oxides) of the metals, described as the semiconductor fine particles. In a case of providing the light-scattering layer 46, it is preferable that the thickness of the light-scattering layer is set to 10% to 50% of the thickness of the photoconductor layer 42.
The light-scattering layer 46 is preferably the light-scattering layer described in JP2002-289274A, and the description of JP2002-289274A is preferably incorporated herein by reference.

- Metal Oxide Layer Coating Film -

In the present invention, semiconductor fine particles which form a photoconductor layer preferably have a metal oxide coating film on a surface thereof. As the metal oxide which forms a metal oxide coating film, the metal oxide mentioned as the semiconductor fine particles can be used, and the metal oxide may be the same as or different from the semiconductor fine particles. This metal oxide coating film is usually formed on a thin film, and preferably has a thickness of 0.1 to 100 nm, for example. In the present invention, in a case where the semiconductor fine particles have a metal oxide coating film, the metal complex dye is adsorbed on the semiconductor fine particles via the metal oxide coating film. A method for forming the metal oxide coating film is as described above.
In the present invention, in particular, it is preferable that the surfaces of the electrically conductive support and the semiconductor fine particles each have the metal oxide coating film. In this case, each of the metal oxide coating films may be formed of the same or different kinds of metal oxides.

- Dye -

In the photoelectric conversion element 10 and the dye-sensitized solar cell 20, the semiconductor fine particles have at least the above-mentioned metal complex dye represented by Formula (1) as a sensitizing dye. Here, the aspect in which the metal complex dye is carried onto the surfaces of the semiconductor fine particles encompasses an aspect in which the metal complex dye is deposited on the surfaces of the semiconductor fine particles, an aspect in which the metal complex dye is adsorbed onto the surfaces of the semiconductor fine particles, and a mixture of the aspects. The adsorption encompasses chemical adsorption and physical adsorption, with the chemical adsorption being preferable.
The metal complex dye is as described above.
The semiconductor fine particles may carry other metal complex dyes, the above-mentioned co-adsorbent, or the like in combination with the metal complex dye represented by Formula (1). Such other metal complex dye is the same as the above-mentioned dye that can be used in combination.
The photoconductor layer includes an electrolyte. The electrolyte included in the photoconductor layer may be the same as or different from the electrolyte included in the charge transfer layer, but they are preferably the same.
It is preferable that a short circuit-preventing layer is formed between the electrically conductive support 1 or 41 and the photoconductor layer 2 or 42 so as to prevent reverse current due to a direct contact between the electrolyte included in the photoconductor layer 2 or 42 and the electrically conductive support 1 or 41.
In addition, it is preferable to use a spacer S (see Fig. 2) or a separator, so as to prevent contact between the light-receiving electrode 5 or 40 and the counter electrode 4 or 48.

<Charge Transfer Layer>

The charge transfer layers 3 and 47 are layers having a function of complementing electrons for the oxidized forms of the dye 21, and are provided between the light-receiving electrode 5 or 40 and the counter electrode 4 or 48.
The charge transfer layers 3 and 47 include electrolytes. Here, the expression, "the charge transfer layer includes an electrolyte", is used to inclusion of both of an aspect in which the charge transfer layer consists of only electrolytes and an aspect in which the charge transfer layer consists of electrolytes and materials other than the electrolytes.
The charge transfer layers 3 and 47 may be any of a solid form, a liquid form, a gel form, or a mixture thereof.

- Electrolyte -

Examples of the electrolyte include a liquid electrolyte having a redox pair dissolved in an organic solvent, and

a so-called gel electrolyte in which a molten salt containing a redox pair and a liquid having a redox pair dissolved in an organic solvent are impregnated in a polymer matrix. Among those, in a view of photoelectric conversion efficiency, a liquid electrolyte is preferable.

Examples of the redox pair include a combination of iodine and an iodide (preferably an iodide salt or an iodide ionic liquid, and preferably lithium iodide, tetrabutylammonium iodide, tetrapropylammonium iodide, and methylpropylimidazolium iodide), a combination of an alkylviologen (for example, methylviologen chloride, hexylviologen bromide, and benzylviologen tetrafluoroborate) and a reductant thereof, a combination of a polyhydroxybenzene (for example, hydroquinone and naphthohydroquinone) and an oxidized form thereof, a combination of a divalent iron complex and a trivalent iron complex (for example, a combination of potassium ferricyanide and potassium ferrocyanide), and a combination of a divalent cobalt complex and a trivalent cobalt complex. Among these, a combination of iodine and an iodide, or a combination of a divalent cobalt complex and a trivalent cobalt complex is preferable, and a combination of iodine and an iodide is particularly preferable.

As the cobalt complex, the complex represented by Formula (CC) described in paragraph Nos. 0144 to 0156 of JP2014-82189A is preferable, and the description of paragraph Nos. 0144 to 0156 of JP2014-82189A is preferably incorporated in the present specification.

In a case where a combination of iodine and iodide is used as an electrolyte, it is preferable that a nitrogen-containing aromatic cation iodide salt as a 5- or 6-membered ring is additionally used.

The organic solvent which is used in a liquid electrolyte and a gel electrolyte is not particularly limited, but is preferably an aprotic polar solvent (for example, acetonitrile, propylene carbonate, ethylene carbonate, dimethylformamide, dimethylsulfoxide, sulfolane, 1,3-dimethylimidazolinone, and 3-methyloxazolidinone).

In particular, as the organic solvent which is used for a liquid electrolyte, a nitrile compound, an ether compound, an ester compound, or the like is preferable, a nitrile compound is more preferable, and acetonitrile or methoxypropionitrile is particularly preferable.

With regard to the molten salt or the gel electrolyte, those described in paragraph No. 0205 and paragraph Nos. 0208 to 0213 of JP2014-139931A are preferable, and the descriptions of paragraph No. 0205 and paragraph Nos. 0208 to 0213 of JP2014-139931A are preferably incorporated herein by reference.

The electrolyte may contain aminopyridine compounds, benzimidazole compounds, aminotriazole compounds, aminothiazole compounds, imidazole compounds, aminotriazine compounds, urea compounds, amide compounds, pyrimidine compounds, and heterocycles not including nitrogen, in addition to pyridine compounds such as 4-t-butylpyridine, as an additive.

Moreover, a method of control ling the moisture content of the electrolytic solution may be employed in order to enhance the photoelectric conversion efficiency. Preferred examples of the method of controlling the moisture content include a method of controlling the concentration, and a method of adding a dehydrating agent. The moisture content of the electrolytic solution is preferably adjusted to 0% to 0.1% by mass.

Iodine can also be used as a clathrate compound of iodine with cyclodextrin. Furthermore, a cyclic amidine may be used, or an antioxidant, a hydrolysis inhibitor, a decomposition inhibitor, or zinc iodide may be added.

A solid-state charge transport layer such as a p-type semiconductor or a hole transport material, for example, CuI or CuNCS, may be used in place of the liquid electrolyte and the quasi-solid-state electrolyte as described above. Moreover, the electrolytes described in Nature, vol. 486, p. 487 (2012) and the like may also be used. For a solid-state charge transport layer, an organic hole transport material may be used. As the organic hole transport material, those described in paragraph No. 0214 of JP2014-139931A are preferable, and the description in paragraph No. 0214 of JP2014-139931A is hereby incorporated by reference in its entirety.

The redox pair serves as an electron carrier, and accordingly, it is preferably contained at a certain concentration. The concentration of the redox pair in total is preferably 0.01 mol/L or more, more preferably 0.1 mol/L or more, and particularly preferably 0.3 mol/L or more. In this case, the upper limit is not particularly limited, but is usually approximately 5 mol/L.

<Counter Electrode>

The counter electrodes 4 and 48 preferably work as a positive electrode in a dye-sensitized solar cell. The counter electrodes 4 and 48 usually have the same configurations as the electrically conductive support 1 or 41, but in a configuration in which strength is sufficiently maintained, a substrate 44 is not necessarily required. A preferred structure of the counter electrodes 4 and 48 is a structure having a high charge collecting effect. At least one of the electrically conductive support 1 or 41 and the counter electrode 4 or 48 should be substantially transparent so that light may reach the photoconductor layers 2 and 42. In the dye-sensitized solar cell of the present invention, the electrically conductive support 1 or 41 is preferably transparent to allow solar light to be incident from the side of the electrically conductive support 1 or 41. In this case, the counter electrodes 4 and 48 more preferably have light reflecting properties. As the counter electrodes 4 and 48 of the dye-sensitized solar cell, glass or plastics on which a metal or an electrically conductive

oxide is deposited are preferable, and glass on which platinum is deposited is particularly preferable. In the dye-sensitized solar cell, a lateral side of the cell is preferably sealed with a polymer, an adhesive, or the like in order to prevent evaporation of components.

[Method for Producing Photoelectric Conversion Element and Dye-Sensitized Solar Cell]

The method for producing a photoelectric conversion element of the present invention includes a step of bringing semiconductor fine particles into contact with the dye solution for a photoelectric conversion element of the present invention as the step of adsorbing a metal complex dye onto semiconductor fine particles.

Hereinbelow, the method for producing a photoelectric conversion element of the present invention will be sequentially described.

In the method for producing a photoelectric conversion element of the present invention, a common production method or condition for the photoelectric conversion element and the dye-sensitized solar cell can be applied without particular limitation except for the step of adsorbing the metal complex dye.

First, an electrically conductive support was prepared as described above, and a layer of semiconductor fine particles was formed on a surface of the electrically conductive support. The layer of the semiconductor fine particles can be formed by, for example, applying semiconductor fine particles on an electrically conductive support, followed by calcination at a temperature of 100°C to 800°C for 10 minutes to 10 hours. Thus, the semiconductor fine particles can be adhered to each other. A temperature for film formation is preferably 60°C to 600°C in a case where glass is used as a material for an electrically conductive support or a substrate.

The amount of the semiconductor fine particles to be applied per square meters of a surface area of the electrically conductive support is 0.5 to 500 g, and preferably 5 to 100 g.

In addition, a light-scattering layer 46 is formed in the same manner, as desired, and further, the above-mentioned metal oxide layer coating film is formed.

Then, the metal complex dye is adsorbed on surfaces of the semiconductor fine particles constituting the layer of the semiconductor fine particles thus formed, and the like.

In this step, the dye solution for a photoelectric conversion element of the present invention is used.

Furthermore, a dye solution for a photoelectric conversion element, which has been prepared using the kit for preparing a dye solution, can also be used. In this case, a dye agent and a liquid agent are mixed as described above, and a solid content is removed, as desired, thereby preparing a dye solution for a photoelectric conversion element. As a method and a condition for preparing the dye solution for a photoelectric conversion element, common methods and conditions can be appropriately determined. The amount of the dye agent to be used is appropriately determined, taking the amount of the dye concentration and the metal complex dye to be used in the dye solution for a photoelectric conversion element into consideration.

A method for adsorbing the dye is not particularly limited as long as the semiconductor fine particles and the dye solution for a photoelectric conversion element of the present invention can be brought into contact with each other. Example thereof include a method in which a layer of the semiconductor fine particles is immersed in a dye solution for a photoelectric conversion element (hereinafter also referred to as an immersion method in some cases), or a method in which a dye solution for a photoelectric conversion element is applied onto the layer of semiconductor fine particles (hereinafter also referred to as an application method in some cases).

The amount of the metal complex dye to be used cannot be uniformly determined according to the dye solution for a photoelectric conversion element of the present invention to be used, but is preferably 0.01 to 100 mmoles, more preferably 0.1 to 50 mmoles, still more preferably 0.1 to 10 mmoles, per square meter of the surface area of the electrically conductive support.

The contacting temperature is preferably 0°C to 50°C, and more preferably 15°C to 40°C.

In the immersion method, the immersion time (adsorption time) is preferably 10 minutes to 72 hours, more preferably 20 minutes to 48 hours, and still more preferably 30 minutes to 24 hours.

In the immersion method, it is usually preferable to leave the layer of the semiconductor fine particles in a state of being immersed in the dye solution.

In the present invention, high photoelectric conversion efficiency can be achieved even with a shortened adsorption time, as described above. Thus, it is possible to enhance production efficiency while not decreasing the performance of the photoelectric conversion element and the solar cell, each produced. For example, in a view of production efficiency, the immersion time can be set to preferably 10 minutes to 20 hours, and more preferably 10 minutes to 5 hours.

In the application method, a method for applying the dye solution is not particularly limited, and a common application method such as spin coating, extrusion die coating, blade coating, bar coating, screen printing, stencil printing, roll coating, curtain coating, spray coating, dip coating, and ink jet printing can be used. Among those, the spin coating method, the screen printing method, or the like is preferable.

The application condition is not particularly limited, and examples thereof include the following conditions.

In the application method, it is preferable to provide a time for adsorbing a dye from the initiation of application to the next step. The adsorption time is preferably the same as the adsorption time in the immersion method.

In the immersion method and the application method, the semiconductor fine particles (a layer thereof) may be washed. Thus, the dye solution remaining in the semiconductor fine particles is removed. Examples of the washing method include a method in which a washing liquid is sprayed onto semiconductor fine particles, a method in which semiconductor fine particles are washed out with a washing liquid, and a method in which semiconductor fine particles are immersed in a washing liquid. The washing liquid to be used is not particularly limited, and examples thereof include solvents other than the alcohol solvents.

In the immersion method and the application method, it is preferable to subsequently dry the dye solution for a photoelectric conversion element. Examples of the drying method include natural drying, air-blowing drying, heating drying, and vacuum drying. Among those, natural drying or air-blowing drying is preferable.

The heating drying only needs to be a step of performing drying under heating at room temperature (25°C) or higher, and the heating temperature is, for example, preferably 25°C to 80°C, and more preferably 25°C to 50°C.

In this manner, the metal complex dye is adsorbed on surfaces of the semiconductor fine particles to form a photoconductor layer.

The amount of the dye 21 to be adsorbed onto the semiconductor fine particles 22 is appropriately set according to the dye solution for a photoelectric conversion element of the present invention and the contact condition, and the amount is preferably 0.001 to 1 mmoles, and more preferably 0.1 to 0.5 mmoles, per gram of the semiconductor fine particles. By setting the amount of the dye to such a range, the sensitization effect on the semiconductor fine particles is sufficiently obtained.

After the metal complex dye is carried onto the semiconductor fine particles, the surfaces of the semiconductor fine particles may be treated using an amine compound, as desired. Preferred examples of the amine compound include pyridine compounds (for example, 4-t-butylpyridine and polyvinylpyridine). These may be used as they are in a case where they are liquids, or may be used in a state where they are dissolved in an organic solvent.

Then, a charge transfer layer, a counter electrode, or the like can be provided for a light-receiving electrode including the photoconductor layer by a common method to produce a photoelectric conversion element.

In addition, an external circuit 6 can be connected with the electrically conductive support 1 and the counter electrode 4 of the photoelectric conversion element thus manufactured to produce a dye-sensitized solar cell.

## EXAMPLES

Hereinafter, the present invention will be described in more detail, based on Examples, but the present invention is not limited thereto.

[Preparation Example 1: Preparation of Dye Solution for Photoelectric Conversion Element]

As seen in Table 2 which will be described later, a metal complex dye (dye agent) was mixed with a solvent (liquid agent) at 25°C such that the content (concentration) of the metal complex dye reached $2\times10^{-4}$ moles/L. Further, 10 moles of chenodeoxycholic acid (third agent) as a co-adsorbent were added thereto per mole of the metal complex dye to prepare each of dye solutions for a photoelectric conversion element.

In Table 2, the above-mentioned alcohol solvent is denoted as a "solvent A" and the solvents other than the alcohol solvent is denoted as a "solvent B".

In Table 2, the molecular weight, the grade, and the total number of carbon atoms of the alcohol solvent are shown together.

The metal complex dyes D-1 to D-8, R-1, and R-2 used are shown below.

In the following metal complex dye, TBA represents tetrabutylammonium.

The metal complex dyes D-1 to D-8 were each synthesized in accordance with the method described in JP2013-072079A.

As the metal complex dye R-1, a commercially available product (Production No.: 791245, manufactured by Aldrich) was used.

A dye R-2 was synthesized with reference to the method and the condition described in Journal of Material Chemistry A, 2013, 1, p. 11295-11305.

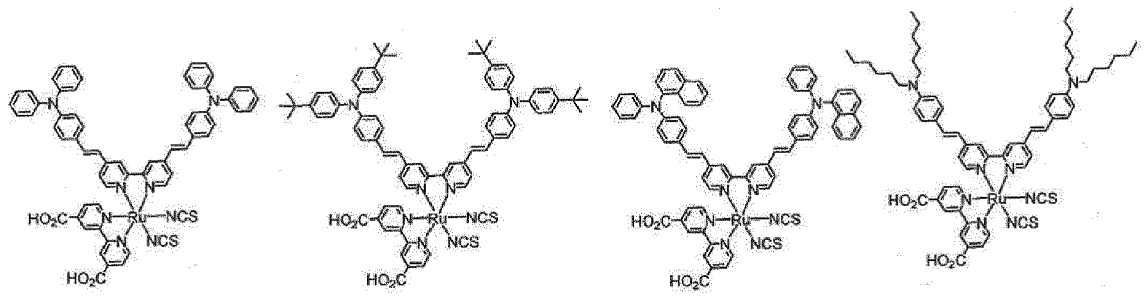

D-1 D-2 D-3 D-4

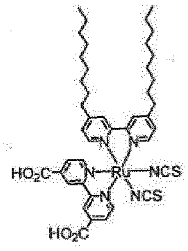

D-5

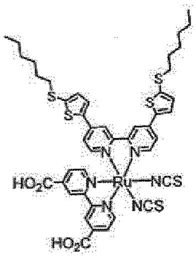

D-6

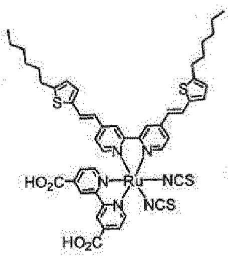

D-7

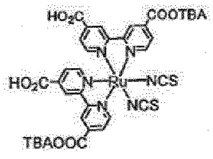

D-8

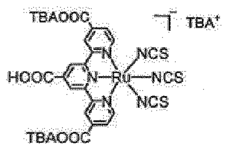

R-1

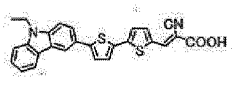

R-2

[Production Example 1: Production of Dye-Sensitized Solar Cell]

Using the dye solution for a photoelectric conversion element prepared in Preparation Example 1, a dye-sensitized solar cell 20 (in a scale of 5 mm×5 mm) shown in Fig. 2 was produced by a procedure shown below, and evaluated on the following performance. The results are shown in Table 2.

(Manufacture of Light-Receiving Electrode Precursor)

An electrically conductive support 41 was prepared, in which a fluorine-doped $SnO_2$ electrically-conductive film (transparent electrically-conductive film 43, film thickness of 500 nm) was formed on a glass substrate (substrate 44, thickness of 4 mm). Further, a glass substrate having a $SnO_2$ electrically-conductive film formed thereon was immersed in a 40 mM aqueous titanium trichloride solution for 30 minutes, washed with ultrapure water and ethanol, and then calcined at 450°C to form a thin film layer of the titania coating film (metal oxide coating film, not shown in Fig. 2) on the $SnO_2$ electrically-conductive film.

A titania paste "18NR-T" (manufactured by DyeSol) was screen-printed on the titania coating film, followed by drying at 120°C. Then, the dried titania paste "18NR-T" was screen-printed, followed by drying at 120°C for 1 hour, and thereafter, the dried titania paste was calcined at 500°C to form a semiconductor layer 45 (film thickness; 5 μm). Further, a titania paste "18NR-AO" (manufactured by DyeSol) was screen-printed on this semiconductor layer 45, and then dried at 120°C for 1 hour. Thereafter, the dried titania paste was calcined at 500°C. Then, this glass substrate was immersed in a 20 mM aqueous titanium trichloride solution, and washed with ultrapure water and then with ethanol, and each glass substrate was heated at 460°C for 30 minutes. Thus, a light-scattering layer 46 (film thickness: 5 μm) was formed on the semiconductor layer 45. By the procedure above, a photoconductor layer 42 (the area of the light-receiving surface; 5 mm×5 mm, film thickness; 10 μm) was formed on the $SnO_2$ electrically-conductive film.

In this manner, a light-receiving electrode precursor not carrying a metal complex dye was manufactured.

(Dye Adsorbing Method)

Next, the metal complex dye was carried onto a photoconductor layer of the obtained light-receiving electrode precursor.

As shown in Table 2, the manufactured light-receiving electrode precursor was immersed in each of the dye

solutions at 25°C for 5 hours or 20 hours, and then pulled out of the dye solution. This was dried at 25°C for 1 hour to manufacture each of light-receiving electrodes 40 having each of the metal complex dyes carried on the light-receiving electrode precursor. The light-receiving electrode obtained after immersion for 5 hours and the light-receiving electrode obtained after immersion for 20 hours were defined as [A] and [B], respectively.

(Assembly of Dye-Sensitized Solar Cell)

Then, a platinum electrode (the thickness of a Pt thin film; 100 nm) having the same shape and size as those of the electrically conductive support 41 was manufactured as a counter electrode 48. Further, 0.001 M (moles/L) of iodine, 0.1 M of lithium iodide, 0.5 M of 4-t-butylpyridine, and 0.6 M of 1,2-dimethyl-3-propylimidazolium iodide as an electrolytic solution were dissolved in acetonitrile to prepare a liquid electrolyte. In addition, a Spacer S (trade name: "SURLYN") manufactured by E. I. du Pont de Nemours and Company, which has a shape matching to the size of the photoconductor layer 42, was prepared.

Each of the light-receiving electrodes 40 manufactured as above and the counter electrode 48 were arranged to face each other through the spacer-S and thermally compressed, and then the liquid electrolyte was filled from the inlet for the electrolytic solution between the photoconductor layer 42 and the counter electrode 48, thereby forming a charge transfer layer 47. The outer periphery and the inlet for the electrolytic solution of thus manufactured cell were sealed and cured using a resin XNR-5516 manufactured by Nagase ChemteX Corporation, thereby producing each of dye-sensitized solar cells.

[Evaluation of Dye-Sensitized Solar Cell]

(Detection of Remaining Alcohol Solvent)

Each of the produced dye-sensitized solar cells was disassembled to extract the photoconductor layer. This photoconductor layer was immersed in a solvent (a methanol solution of tetrabutylammoniumhydroxide) capable of allowing the metal complex dye to leave from the semiconductor fine particles. This solvent was analyzed by gas chromatography (GC), whereby the alcohol solvent included in the dye solution used in the above-mentioned dye adsorption method could be detected.

(Evaluation of Photoelectric Conversion Efficiency: Evaluation Method [I] (High-Illuminance Solar Light))

With respect to each of the dye-sensitized solar cells produced using the light-receiving electrode [A], a cell characteristic test was carried out.

The cell characteristic test was carried out by irradiating each of the dye-sensitized solar cells with an artificial solar light of 1,000 $W/m^2$ (100,000 lux) from a xenon lamp through an AM1.5 filter, using a solar simulator (PEC-L15 (manufactured by Peccell Technologies)). The photoelectric conversion efficiency was determined by measuring the current-voltage characteristics of each of the dye-sensitized solar cells irradiated with the artificial solar light using a source meter "Keithley 2401" (manufactured by Tektronix, Inc.). The obtained photoelectric conversion efficiency was defined as a photoelectric conversion efficiency [$I^5$].

With respect to each of the dye-sensitized solar cells, a relative value of the photoelectric conversion efficiency [$I^5$] with respect to the photoelectric conversion efficiency [$I^5{}_{c1}$] in the comparative dye-sensitized solar cell CSD-1 was determined. Evaluation of the photoelectric conversion efficiency [$I^5$] was to examine which of ranks in the evaluation standards below are granted on the obtained relative values.

In the present test, the photoelectric conversion efficiencies [$I^5$] (relative value) are evaluated as follows: Ranks S, A, and B denote ranges at allowable levels, with Ranks S and A being at preferable levels.

S: More than 1.25 times
A: More than 1.2 times and 1.25 times or less
B: More than 1.15 times and 1.2 times or less
C: More than 1.05 times and 1.15 times or less
D: 1.05 times or less

In Table 2, the "standard" means 1.0 time.

The photoelectric conversion efficiency [$I^5$] of each of the dye-sensitized solar cells Nos. SD-1 to SD-40 of the present invention sufficiently functioned as a dye-sensitized solar cell (photoelectrochemical cell) under a high-illuminance solar light. For example, the photoelectric conversion efficiency [$I^5$] of the dye-sensitized solar cell No. SD-3 was 8.1%.

(Evaluation of Photoelectric Conversion Efficiency: Evaluation Method [II] (Low-Illuminance Environment: Indoor Light))

With respect to each of the dye-sensitized solar cells produced using the light-receiving electrode [A], a cell characteristic test was carried out.

The cell characteristic test was carried out using a white light-emitting diode (Product No.: LDA8N-G-K/D/60W) manufactured by Toshiba. Adjustment of an illuminance (3,000 $\mu W/cm^2$ (10,000 lux)) was carried out using ND filters (ND1 to ND80) commercially available from Shibuya Optical Co., Ltd. Measurement of the regulated illuminance was confirmed using a spectrophotometer USB4000 manufactured by Ocean Photonics, Inc. The photoelectric conversion efficiency was determined by measuring the current-voltage characteristics of each of the dye-sensitized solar cells irradiated with light having an adjusted illuminance using a source meter "Keithley 2401" (manufactured by Tektronix, Inc.). The obtained photoelectric conversion efficiency was defined as a photoelectric conversion efficiency [$II^5$].

With respect to each of the dye-sensitized solar cells, a relative value of the photoelectric conversion efficiency [$II^5$] with respect to the photoelectric conversion efficiency [$II^5_{c1}$] in the comparative dye-sensitized solar cell No. CSD-1 was determined. Evaluation of the photoelectric conversion efficiency [$II^5$] was to examine which of ranks in the evaluation standards below are granted on the obtained relative values.

In the present test, the photoelectric conversion efficiencies [$II^5$] (relative value) are evaluated as follows: Ranks S, A, and B denote ranges at allowable levels, with Ranks S and A being at preferable levels.

S: More than 1.2 times
A: More than 1.15 times and 1.2 times or less
B: More than 1.1 times and 1.15 times or less
C: More than 1.05 times and 1.1 times or less
D: 1.05 times or less

In Table 2, the "standard" means 1.0 time.

The photoelectric conversion efficiency [$II^5$] of each of the dye-sensitized solar cells Nos. SD-1 to SD-40 of the present invention sufficiently functioned as a dye-sensitized solar cell in a low-illuminance environment. For example, the photoelectric conversion efficiency [$II^5$] of the dye-sensitized solar cell No. SD-3 was 11%.

(Evaluation of Photoelectric Conversion Efficiency: Evaluation Method [III] (Ratio of Photoelectric Conversion Efficiency))

With respect to each of the dye-sensitized solar cells produced using the light-receiving electrode [A] and the light-receiving electrode [B], an effect of the adsorption time was evaluated.

Also, with respect to each of the dye-sensitized solar cells produced using the light-receiving electrode [B], the photoelectric conversion efficiency [$I^{20}$] was measured in the same manner as in "Evaluation of Photoelectric Conversion Efficiency: Evaluation Method [I]".

With respect to each of the dye-sensitized solar cells, a ratio Gd was calculated using the following equation, with respect to the photoelectric conversion efficiencies [$I^5$] and [$I^{20}$] measured in a high-illuminance solar light. Using the ratio Gd of the photoelectric conversion efficiencies, an effect of the adsorption time on the photoelectric conversion efficiency was evaluated.

It was examined which of the ranks in the evaluation standards shown blow are granted on the ratios Gd of the photoelectric conversion efficiencies. In the present evaluation, as a value of the ratio Gd is closer to 1, the effect on the adsorption time is smaller, and even in a case where the adsorption time is shortened, it is shown that photoelectric conversion efficiency can be maintained. For the evaluations of dependency of the adsorption time, Ranks S, A, and B denote ranges at allowable levels, with Ranks S and A being at preferable levels.

$$\text{Equation: Ratio Gd of photoelectric conversion efficiencies} = I^5/I^{20}$$

S: 0.97 or more and less than 1.03
A: 0.94 or more and less than 0.97, or 1.03 or more and less than 1.06
B: 0.90 or more and less than 0.94, or 1.06 or more and less than 1.10
C: 0.85 or more and less than 0.90, or 1.10 or more and less than 1.15
D: Less than 0.85, or 1.15 or more

[Table 2-1]

| Dye-sensitized solar cell No. | Dye solvent for photoelectric conversion element | | | | | | | | | Evaluation | | | Note |
|---|---|---|---|---|---|---|---|---|---|---|---|---|---|
| | No. | Metal complex dye | Type of solvent | | Composition [% by volume] of solvent | | Solvent A | | | Photoelectric conversion efficiency | | Gd | |
| | | | Solvent A | Solvent B | Solvent A | Solvent B | Molecular weight | Grade | Total number of carbon atoms | $[I^5]$ | $[II^5]$ | | |
| SD-1 | CD-1 | D-1 | Isobutanol | - | 100 | - | 74.1 | 1 | 4 | S | A | S | Present invention |
| SD-2 | CD-2 | D-1 | Isobutanol | acetonitrile | 50 | 50 | 74.1 | 1 | 4 | A | A | A | Present invention |
| SD-3 | CD-3 | D-2 | Isobutanol | - | 100 | - | 74.1 | 1 | 4 | S | S | S | Present invention |
| SD-4 | CD-4 | D-2 | Isobutanol | acetonitrile | 75 | 25 | 74.1 | 1 | 4 | S | A | A | Present invention |
| SD-5 | CD-5 | D-2 | Isobutanol | acetonitrile | 50 | 50 | 74.1 | 1 | 4 | A | A | A | Present invention |
| SD-6 | CD-6 | D-2 | Isobutanol | acetonitrile | 25 | 75 | 74.1 | 1 | 4 | B | A | B | Present invention |
| SD-7 | CD-7 | D-2 | 2,2-Dimethyl-1-propanol | - | 100 | - | 88.2 | 1 | 5 | S | S | S | Present invention |
| SD-8 | CD-8 | D-2 | 2,2-Dimethyl-1-propanol | DMF | 50 | 50 | 88.2 | 1 | 5 | A | A | A | Present invention |
| SD-9 | CD-9 | D-2 | 2,2-Dimethyl-1-propanol | DMF | 40 | 60 | 88.2 | 1 | 5 | B | A | B | Present invention |
| SD-10 | CD-10 | D-2 | 2-Methyl-1-butanol | - | 100 | - | 88.2 | 1 | 5 | S | S | S | Present invention |
| SD-11 | CD-11 | D-2 | 3-Methyl-1-butanol | - | 100 | - | 88.2 | 1 | 5 | S | S | S | Present invention |
| SD-12 | CD-12 | D-2 | 2-Ethyl-1-hexanol | - | 100 | - | 130.2 | 1 | 8 | A | A | A | Present invention |

(continued)

| Dye-sensitized solar cell No. | Dye solvent for photoelectric conversion element | | | | | | | | | Evaluation | | | Note |
|---|---|---|---|---|---|---|---|---|---|---|---|---|---|
| | No. | Metal complex dye | Type of solvent | | Composition [% by volume] of solvent | | Solvent A | | | Photoelectric conversion efficiency | | Gd | |
| | | | Solvent A | Solvent B | Solvent A | Solvent B | Molecular weight | Grade | Total number of carbon atoms | [$I^5$] | [$II^5$] | | |
| SD-13 | CD-13 | D-2 | 2-Butyl-1-octanol | - | 100 | - | 186.3 | 1 | 12 | B | A | B | invention |
| SD-14 | CD-14 | D-2 | 2-Octyl-1-dodecanol | - | 100 | - | 298.6 | 1 | 20 | B | A | B | Present invention |
| SD-15 | CD-15 | D-2 | 2-Butanol | - | 100 | - | 74.1 | 2 | 4 | A | B | A | Present invention |
| SD-16 | CD-16 | D-2 | 2-Octanol | - | 100 | - | 130.2 | 2 | 8 | A | B | A | Present invention |
| SD-17 | CD-17 | D-2 | 1-Methoxy-2-butanol | - | 100 | - | 104.2 | 2 | 5 | A | B | A | Present invention |
| SD-18 | CD-18 | D-2 | t-Amylalcohol | - | 100 | - | 88.2 | 3 | 5 | B | B | B | Present invention |
| SD-19 | CD-19 | D-2 | t-Amylalcohol | Acetonitrile | 50 | 50 | 88.2 | 3 | 5 | B | B | B | Present invention |
| SD-20 | CD-20 | D-3 | Isobutanol | - | 100 | - | 74.1 | 1 | 4 | S | S | S | Present invention |
| SD-21 | CD-21 | D-4 | Isobutanol | - | 100 | - | 74.1 | 1 | 4 | S | A | A | Present invention |
| SD-22 | CD-22 | D-4 | t-Amylalcohol | - | 100 | - | 88.2 | 3 | 5 | B | B | B | Present invention |

In the table, DMF represents N,N-dimethylformamide.

[Table 2-2]

| Dye-sensitized solar cell No. | Dye solvent for photoelectric conversion element | | | | | | | | | Evaluation | | | Note |
|---|---|---|---|---|---|---|---|---|---|---|---|---|---|
| | No. | Metal complex dye | Type of solvent | | Composition [% by volume] of solvent | | Solvent A | | | Photoelectric conversion efficiency | | Gd | |
| | | | Solvent A | Solvent B | Solvent A | Solvent B | Molecular weight | Grade | Total number of carbon atoms | [I5] | [II5] | | |
| SD-23 | CD-23 | D-5 | Isobutanol | - | 100 | - | 74.1 | 1 | 4 | B | B | B | Present invention |
| SD-24 | CD-24 | D-6 | Isobutanol | - | 100 | - | 74.1 | 1 | 4 | S | A | A | Present invention |
| SD-25 | CD-25 | D-6 | Isobutanol | Acetonitrile | 50 | 50 | 74.1 | 1 | 4 | A | B | A | Present invention |
| SD-26 | CD-26 | D-7 | Isobutanol | - | 100 | - | 74.1 | 1 | 4 | A | A | A | Present invention |
| SD-27 | CD-27 | D-7 | Isobutanol | Acetonitrile | 50 | 50 | 74.1 | 1 | 4 | A | A | B | Present invention |
| SD-28 | CD-28 | D-8 | Isobutanol | - | 100 | - | 74.1 | 1 | 4 | B | B | B | Present invention |
| SD-29 | CD-29 | D-2 | 3-Methoxy-1-butanol | - | 100 | - | 104.2 | 1 | 5 | S | A | A | Present invention |
| SD-30 | CD-30 | D-2 | 2-Isopropoxyethanol | - | 100 | - | 104.2 | 1 | 5 | S | A | S | Present invention |
| SD-31 | CD-31 | D-2 | 1-Methoxy-2-propanol | - | 100 | - | 90.1 | 2 | 4 | S | S | S | Present invention |
| SD-32 | CD-32 | D-2 | 1-Butoxy-2-propanol | - | 100 | - | 132.2 | 2 | 7 | A | A | S | Present invention |
| SD-33 | CD-33 | D-2 | 1-(1-Methoxy-2-propoxy)-2-propanol | - | 100 | - | 148.2 | 2 | 7 | A | A | A | Present invention |

(continued)

| Dye-sensitized solar cell No. | Dye solvent for photoelectric conversion element | | | | | | | | | Evaluation | | | Note |
|---|---|---|---|---|---|---|---|---|---|---|---|---|---|
| | No. | Metal complex dye | Type of solvent | | Composition [% by volume] of solvent | | Solvent A | | | Photoelectric conversion efficiency | | Gd | |
| | | | Solvent A | Solvent B | Solvent A | Solvent B | Molecular weight | Grade | Total number of carbon atoms | $[I^5]$ | $[II^5]$ | | |
| SD-34 | CD-34 | D-2 | 3-Methoxy-1-butanol | DMF | 80 | 20 | 104.2 | 1 | 5 | A | A | A | Present invention |
| SD-35 | CD-35 | D-2 | 2-Isopropoxyethanol | DMF | 80 | 20 | 104.2 | 1 | 5 | A | A | A | Present invention |
| SD-36 | CD-36 | D-2 | 1-Methoxy-2-propanol | DMF | 80 | 20 | 90.1 | 2 | 4 | S | A | S | Present invention |
| SD-37 | CD-37 | D-2 | 1-Butoxy-2-propanol | DMF | 80 | 20 | 132.2 | 2 | 7 | A | A | A | Present invention |
| SD-38 | CD-38 | D-2 | 1-(1-Methoxy-2-propoxy)-2-propanol | DMF | 80 | 20 | 148.2 | 2 | 7 | A | A | A | Present invention |
| SD-39 | CD-39 | D-2 | 3-Methoxy-1-butanol | DMF | 50 | 50 | 104.2 | 1 | 5 | B | A | B | Present invention |
| SD-40 | CD-40 | D-2 | 1-Methoxy-2-propanol | DMF | 50 | 50 | 90.1 | 2 | 4 | A | A | A | Present invention |

In the table, DMF represents N,N-dimethylformamide.

[Table 2-3]

| Dye-sensitized solar cell No. | Dye solvent for photoelectric conversion element | | | | | | | | | Evaluation | | | Note |
|---|---|---|---|---|---|---|---|---|---|---|---|---|---|
| | No. | Metal complex dye | Type of solvent | | Composition [% by volume] of solvent | | Solvent A | | | Photoelectric conversion efficiency | | Gd | |
| | | | Solvent A | Solvent B | Solvent A | Solvent B | Molecular weight | Grade | Total number of carbon atoms | [$I^5$] | [$II^5$] | | |
| CSD-1 | CCD-1 | D-2 | Methanol | | 100 | | 32.1 | 1 | 1 | Standard | Standard | D | Comparative Example |
| CSD-2 | CCD-2 | D-2 | Ethanol | | 100 | | 46.1 | 1 | 2 | D | D | D | Comparative Example |
| CSD-3 | CCD-3 | D-2 | Isopropanol | | 100 | | 60.1 | 2 | 3 | C | C | D | Comparative Example |
| CSD-4 | CCD-4 | D-2 | t-Butanol | | 100 | | 74.1 | 3 | 4 | C | C | D | Comparative Example |
| CSD-5 | CCD-5 | D-2 | t-Butanol | Acetonitrile | 50 | 50 | 74.1 | 3 | 4 | C | C | C | Comparative Example |
| CSR-1 | CCR-1 | R-1 | Isobutanol | | 100 | | 74.1 | 1 | 4 | D | C | C | Comparative Example |
| CSR-2 | CCR-2 | R-1 | t-Butanol | Acetonitrile | 50 | 50 | 74.1 | 3 | 4 | C | C | D | Comparative Example |
| CSR-3 | CCR-3 | R-2 | Isobutanol | | 100 | | 74.1 | 1 | 4 | D | D | C | Comparative Example |
| CSR-4 | CCR-4 | R-2 | t-Butanol | Acetonitrile | 50 | 50 | 74.1 | 3 | 4 | D | D | D | Comparative Example |

From the results shown in Table 2, the following findings can be seen.

With the comparative dye-sensitized solar cells, the photoelectric conversion efficiency was not sufficient and the dependency of the adsorption time on the photoelectric conversion efficiency was high in both a high-illuminance environment and a low-illuminance environment.

In a case of using the dye solutions Nos. CCD-1 and CCD-2 containing a primary alcohol which has a molecular weight of less than 70, does not have a branched chain, and has less than 4 carbon atoms in total; a case of using the dye solution No. CCD-3 containing a secondary alcohol which has a molecular weight of less than 70 and has less than 4 carbon atoms in total; or a case of using the dye solutions Nos. CCD-4 and CCD-5 containing a tertiary alcohol which has less than 5 carbon atoms in total, while containing the metal complex dye represented by Formula (1), neither a high photoelectric conversion efficiency nor little dependency of the adsorption time was shown in all of respective tests (dye-sensitized solar cells Nos. CSD-1 to CSD-5).

In addition, in case of using the dyes R-1 and R-2 which are not the metal complex dye represented by Formula (1), sufficient characteristics were similarly not exhibited in the photoelectric conversion efficiency and the dependency of the adsorption time in each of the environments even with a use of a combination of isobutanol or t-butanol as the solvent (dye-sensitized solar cells Nos. CSR-1 to CSR-4).

In contrast, with the dye-sensitized solar cells produced using the dye solutions containing the metal complex dye represented by Formula (1) and a specific alcohol solvent, high photoelectric conversion efficiency was not exhibited, irrespective of the degree of illuminance, even with a shortened adsorption time.

In particular, in a case of using a primary alcohol as defined in the present invention, the photoelectric conversion efficiency was enhanced, and the dependency of the adsorption time on the photoelectric conversion efficiency also decreased (in cases using the metal complex dye D-2, the dye-sensitized solar cells Nos. SD-3 to SD-14).

Further, as the content ratio of the alcohol solvent in the solvent increased, and in particular, the content ratio reached 50% by volume or more, and above all, 100% by volume, an effect of improving the photoelectric conversion efficiency is enhanced, and thus, the dependency of the adsorption time was excellent (in cases of using the metal complex dye D-2, the dye-sensitized solar cells Nos. SD-3 to SD-6 and SD-7 to SD-9).

As the molecular weight of the alcohol solvent decreased, and in particular, the molecular weight reached 180 or less, an effect of improving the photoelectric conversion efficiency increased (in cases of using the metal complex dye D-2, the dye-sensitized solar cells Nos. SD-7 and SD-10 to SD-14).

Furthermore, with respect to the metal complex dyes, in a case of using the metal complex dyes D-1 to D-3 (metal complex dyes represented by Formula (3)), a high level of the photoelectric conversion efficiency could be provided. Further, in a case of using the metal complex dyes D-4, D-6, and D-7 (metal complex dyes represented by Formula (2)), a high level of photoelectric conversion efficiency could be provided, subsequently to the metal complex dyes D-1 to D-3. With regard to the levels at which the photoelectric conversion efficiency is provided, they were followed by the metal complex dyes D-5 and D-8 (metal complex dyes represented by Formula (1)) (dye-sensitized solar cells Nos. SD-1, 3, 20, 21, 23, 24, 26, and 28).

From the above results, it could be seen that the dye solution of the present invention, containing a combination of the metal complex dye represented by Formula (1) and a specific alcohol solvent, the photoelectric conversion efficiency of the obtained photoelectric conversion element can increase, irrespective of the degree of illuminance, even with a shortened adsorption time, in the production of the photoelectric conversion element or the dye-sensitized solar cell (a step of adsorbing the metal complex dye).

Explanation of References

1, 41: electrically conductive supports
2, 42: photoconductor layers (oxide semiconductor electrodes)
21: dye
22: semiconductor fine particles
3, 47: charge transfer layers
4, 48: counter electrodes
5, 40: light-receiving electrodes
6: circuit
10: photoelectric conversion element
100: system in which a photoelectric conversion element is applied to cell uses
M: operating means (for example, an electric motor)
20: dye-sensitized solar cell
43: transparent electrically-conductive film

44: substrate
45: semiconductor layer
46: light-scattering layer
S: spacer

## Claims

**1.** A dye solution for a photoelectric conversion element, comprising:

at least one metal complex dye represented by Formula (1); and
a solvent including at least one alcohol solvent having a molecular weight of 70 to 300, selected from a primary alcohol having 4 or more carbon atoms in total, which has at least one branched chain, a secondary alcohol having 4 or more carbon atoms in total, which may have a branched chain, and a tertiary alcohol having 5 or more carbon atoms in total, which may have a branched chain,

Formula (1)

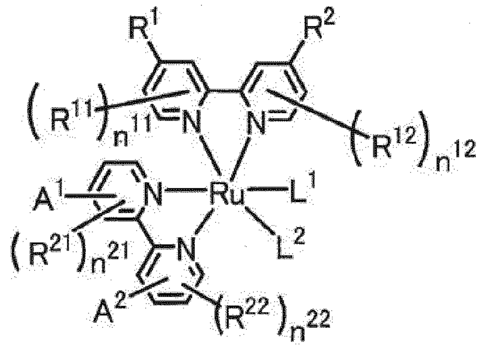

in the formula,

$R^1$ and $R^2$ each independently represent a carboxyl group or a salt thereof, an alkyl group, an ethenyl group, an ethynyl group, an aryl group, a heteroaryl group, an alkoxy group, an alkylthio group, an aryloxy group, an arylthio group, an amino group, or a monovalent group formed by combination of two or more of these groups,
$R^{11}$ and $R^{12}$ each independently represent an alkyl group, an alkenyl group, an alkoxy group, an aryl group, an alkylthio group, a heteroaryl group, an amino group, or a halogen atom, and $R^{11}$ and $R^{12}$ may be linked to each other to form a ring,
$n^{11}$ and $n^{12}$ are each independently an integer of 0 to 3,
$A^1$ and $A^2$ each independently represent an acidic group,
$R^{21}$ and $R^{22}$ each independently represent an alkyl group, an alkenyl group, an aryl group, a cyano group, a halogen atom, or an acidic group, and $R^{21}$ and $R^{22}$ may be linked to each other to form a ring,
$n^{21}$ and $n^{22}$ are each independently an integer of 0 to 3, and
$L^1$ and $L^2$ each independently represent a monodentate ligand, or $L^1$ and $L^2$ represent a bidentate ligand formed by the mutual linking thereof.

**2.** The dye solution for a photoelectric conversion element according to claim 1,
wherein the metal complex dye is represented by Formula (2),

Formula (2)

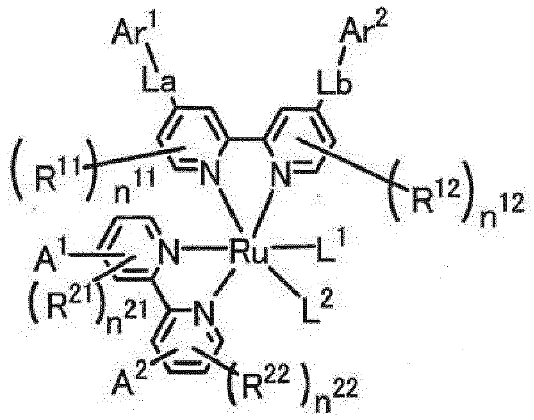

in the formula,

La and Lb each independently represent a single bond, or a conjugated linking group selected from an ethenylene group, an ethynylene group, an arylene group, and a heteroarylene group,
$Ar^1$ and $Ar^2$ each independently represent an aryl group or a heteroaryl group, and $R^{11}$, $R^{12}$, $n^{11}$, $n^{12}$, $A^1$, $A^2$, $R^{21}$, $R^{22}$, $n^{21}$, $n^{22}$, $L^1$, and $L^2$ have the same definitions as $R^{11}$, $R^{12}$, $n^{11}$, $n^{12}$, $A^1$, $A^2$, $R^{21}$, $R^{22}$, $n^{21}$, $n^{22}$, $L^1$, and $L^2$ in Formula (1), respectively.

**3.** The dye solution for a photoelectric conversion element according to claim 2, wherein $Ar^1$ and $Ar^2$ each independently have an alkyl group, an alkoxy group, an alkylthio group, or an amino group as a substituent.

**4.** The dye solution for a photoelectric conversion element according to claim 2 or 3, wherein La and Lb are each an ethenylene group.

**5.** The dye solution for a photoelectric conversion element according to any one of claims 1 to 4, wherein the metal complex dye is represented by Formula (3),

Formula (3)

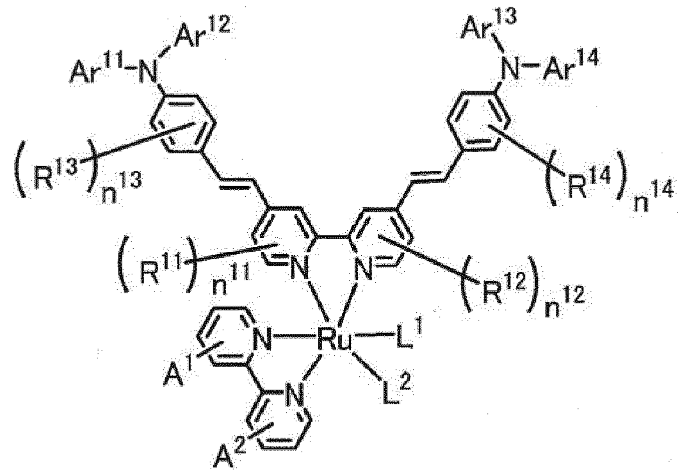

in the formula,

$Ar^{11}$ to $Ar^{14}$ each independently represent an aryl group or a heteroaryl group,
$R^{13}$ and $R^{14}$ each independently represent an alkyl group, an alkoxy group, an aryl group, an alkylthio group, a heteroaryl group, an amino group, or a halogen atom,
$n^{13}$ and $n^{14}$ are each independently an integer of 0 to 4, and
$R^{11}$, $R^{12}$, $n^{11}$, $n^{12}$, $A^1$, $A^2$, $L^1$, and $L^2$ have the same definitions as $R^{11}$, $R^{12}$, $n^{11}$, $n^{12}$, $A^1$, $A^2$, $L^1$, and $L^2$ in Formula (1), respectively.

**6.** The dye solution for a photoelectric conversion element according to any one of claims 1 to 5, wherein $L^1$ and $L^2$ are each independently an isothiocyanate group, a thiocyanate group, an isoselenocyanate group, an isocyanate group, a cyanate group, a halogen atom, a cyano group, an alkylthio group, an arylthio group, an alkoxy group, or an aryloxy group.

**7.** The dye solution for a photoelectric conversion element according to any one of claims 1 to 6, wherein the molecular weight of the alcohol solvent is 70 to 180.

**8.** The dye solution for a photoelectric conversion element according to any one of claims 1 to 7, wherein the volume content ratio of the alcohol solvent in the solvent is 50% or more.

**9.** The dye solution for a photoelectric conversion element according to any one of claims 1 to 8, wherein the solvent includes the alcohol solvent alone.

**10.** The dye solution for a photoelectric conversion element according to any one of claims 1 to 9, wherein the alcohol solvent is the primary alcohol having 4 or more carbon atoms in total, which has at least one branched chain, or the secondary alcohol having 4 or more carbon atoms in total, which may have a branched chain.

**11.** The dye solution for a photoelectric conversion element according to any one of claims 1 to 10, wherein the alcohol solvent is the primary alcohol having 4 or more carbon atoms in total, which has at least one branched chain.

**12.** The dye solution for a photoelectric conversion element according to any one of claims 1 to 11, wherein the alcohol solvent is at least one selected from isobutanol, 2-methyl-1-butanol, 3-methyl-1-butanol, and 2,2-dimethyl-1-propanol.

**13.** A method for producing a photoelectric conversion element, comprising contacting semiconductor fine particles with the dye solution for a photoelectric conversion element according to any one of claims 1 to 12.

**14.** A kit for preparing a dye solution, formed by combination of:

a dye agent containing at least one metal complex dye represented by Formula (1); and
a liquid agent containing a solvent including at least one alcohol solvent having a molecular weight of 70 to 300, selected from a primary alcohol having 4 or more carbon atoms in total, which has at least one branched chain, a secondary alcohol having 4 or more carbon atoms in total, which may have a branched chain, and a tertiary alcohol having 5 or more carbon atoms in total, which may have a branched chain,

Formula (1)

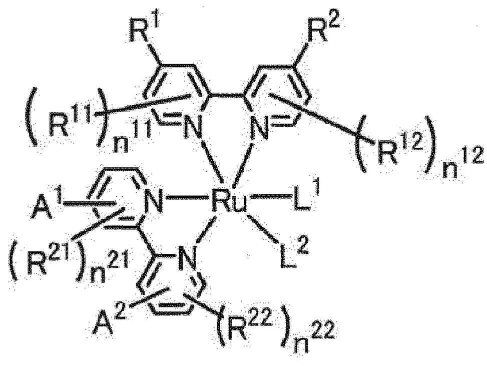

in the formula,

$R^1$ and $R^2$ each independently represent a carboxyl group or a salt thereof, an alkyl group, an ethenyl group, an ethynyl group, an aryl group, a heteroaryl group, an alkoxy group, an alkylthio group, an aryloxy group, an arylthio group, an amino group, or a monovalent group formed by combination of two or more of these groups,
$R^{11}$ and $R^{12}$ each independently represent an alkyl group, an alkenyl group, an alkoxy group, an aryl group, an alkylthio group, a heteroaryl group, an amino group, or a halogen atom, and $R^{11}$ and $R^{12}$ may be linked

to each other to form a ring,
$n^{11}$ and $n^{12}$ are each independently an integer of 0 to 3,
$A^1$ and $A^2$ each independently represent an acidic group,
$R^{21}$ and $R^{22}$ each independently represent an alkyl group, an alkenyl group, an aryl group, a cyano group, a halogen atom, or an acidic group, and $R^{21}$ and $R^{22}$ may be linked to each other to form a ring,
$n^{21}$ and $n^{22}$ are each independently an integer of 0 to 3, and
$L^1$ and $L^2$ each independently represent a monodentate ligand, or $L^1$ and $L^2$ represent a bidentate ligand formed by the mutual linking thereof.

FIG. 1

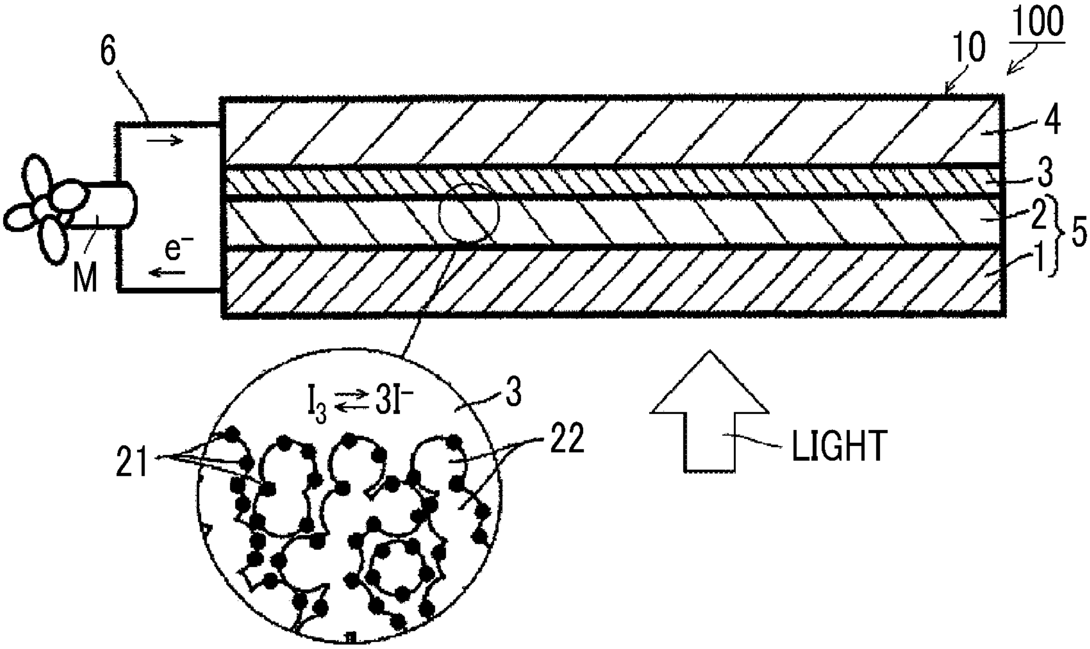

FIG. 2

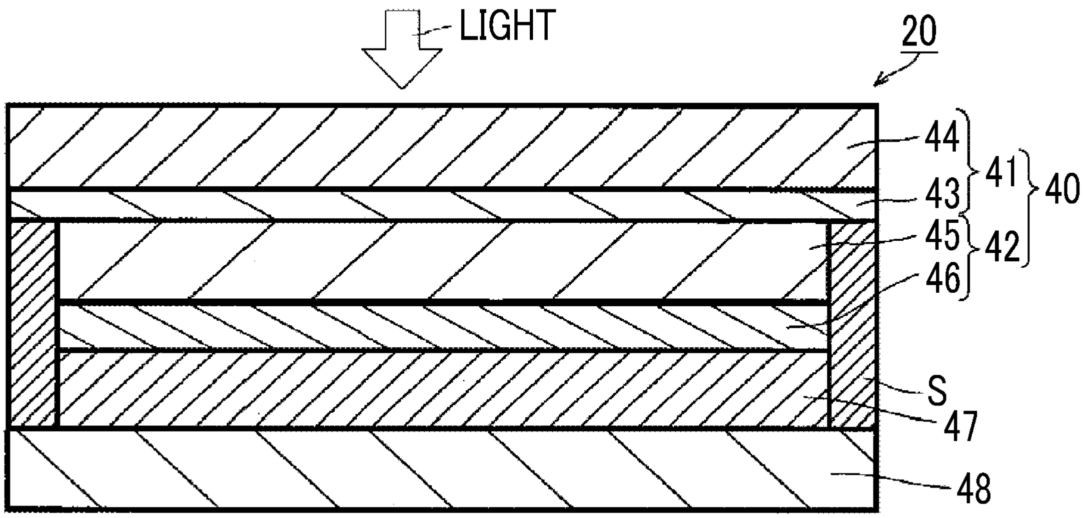

# INTERNATIONAL SEARCH REPORT

International application No. PCT/JP2017/005987

**A. CLASSIFICATION OF SUBJECT MATTER**

*H01G9/20*(2006.01)i, *C09B57/10*(2006.01)i, *C09B67/44*(2006.01)i, *H01L51/44*(2006.01)i, *C07D213/22*(2006.01)n, *C07D213/38*(2006.01)n, *C07D213/79*(2006.01)n, *C07D409/14*(2006.01)n, *C07F15/00*(2006.01)n

According to International Patent Classification (IPC) or to both national classification and IPC

**B. FIELDS SEARCHED**

Minimum documentation searched (classification system followed by classification symbols)

H01G9/20, C09B57/10, C09B67/44, H01L51/44, C07D213/22, C07D213/38, C07D213/79, C07D409/14, C07F15/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2012-216483 A (Sony Corp.), 08 November 2012 (08.11.2012), claims; examples; paragraphs [0074] to [0076] (Family: none) | 1-4,6-14 |
| X | JP 2013-161775 A (Peccell Technologies, Inc.), 19 August 2013 (19.08.2013), claims; examples (Family: none) | 1-4,6-14 |
| A | JP 2015-233151 A (Fujifilm Corp.), 24 December 2015 (24.12.2015), claims; examples (Family: none) | 1-14 |

☒ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| 20 April 2017 (20.04.17) | 09 May 2017 (09.05.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2017/005987

C (Continuation). DOCUMENTS CONSIDERED TO BE RELEVANT

| Category* | Citation of document, with indication, where appropriate, of the relevant passages | Relevant to claim No. |
|---|---|---|
| A | JP 2013-072079 A (Fujifilm Corp.), 22 April 2013 (22.04.2013), claims; examples & WO 2013/047384 A1 & CN 103843093 A & KR 10-2014-0069291 A | 1-14 |
| A | WO 2015/190398 A1 (Fujifilm Corp.), 17 December 2015 (17.12.2015), claims; examples & TW 201605845 A | 1-14 |
| A | JP 2013-144721 A (Ube Industries, Ltd.), 25 July 2013 (25.07.2013), claims; examples & WO 2013/089194 A1 & TW 201331212 A | 1-14 |
| A | JP 2013-058424 A (Sony Corp.), 28 March 2013 (28.03.2013), claims; examples (Family: none) | 1-14 |
| A | WO 2011/049027 A1 (Ube Industries, Ltd.), 28 April 2011 (28.04.2011), claims; examples & US 2012/0204959 A1 claims; examples & EP 2492318 A1 & CN 102656236 A & KR 10-2012-0099026 A & TW 201130800 A | 1-14 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2013072079 A
- JP 2001291534 A
- JP 2014082187 A
- US 4927721 A
- US 4684537 A
- US 5084365 A
- US 5350644 A
- US 5463057 A
- US 5525440 A
- JP 7249790 A
- JP H07249790 A
- JP 2001185244 A
- JP 2001210390 A
- JP 2003217688 A
- JP 2004220974 A
- JP 2008135197 A
- JP 2005135902 A
- JP 2001160425 A
- JP 2003123859 A
- JP 2002260746 A
- JP 2002289274 A
- JP 2014082189 A
- JP 2014139931 A

### Non-patent literature cited in the description

- *J. Phys. Chem.,* 2011, vol. A (115), 6641-6645
- *Nature,* 2012, vol. 486, 487
- *Journal of Material Chemistry A,* 2013, vol. 1, 11295-11305